# EUROPEAN PATENT SPECIFICATION

(11) **EP 3 950 328 B1**
(45) Date of publication and mention of the grant of the patent: **24.07.2024**
(21) Application number: 20779966.9
(22) Date of filing: 24.03.2020
(51) Int. Cl.: B32B 27/00, B32B 27/20, H01L 23/373, C08L 101/12, C08L 71/00, C08J 5/18, C08K 3/38, H05K 7/20

(54) **THERMALLY CONDUCTIVE RESIN SHEET, LAMINATED HEAT DISSIPATION SHEET, HEAT DISSIPATION CIRCUIT BOARD, AND POWER SEMICONDUCTOR DEVICE**
WÄRMELEITENDE HARZSCHICHT, LAMINIERTE WÄRMEABLEITUNGSSCHICHT, WÄRMEABLEITUNGSLEITERPLATTE UND LEISTUNGSHALBLEITERVORRICHTUNG
FEUILLE DE RÉSINE THERMOCONDUCTRICE, FEUILLE LAMINÉE DE DISSIPATION DE CHALEUR, CARTE DE CIRCUIT IMPRIMÉ DE DISSIPATION DE CHALEUR ET DISPOSITIF SEMI-CONDUCTEUR DE PUISSANCE

(30) Priority: 26.03.2019 JP 2019059173
(43) Date of publication of application: 09.02.2022
(73) Proprietor: Mitsubishi Chemical Corporation, Chiyoda-ku Tokyo 100-8251 (JP)
(72) Inventor: EBITANI, Toshiaki, Tokyo 100-8251 (JP); MATSUI, Jun, Tokyo 100-8251 (JP)
(74) Representative: Hoffmann Eitle
(86) International application number: PCT/JP2020/012892
(87) International publication number: WO 2020/196477

(56) References cited:
- EP-A1- 3 221 392
- EP-B1- 3 221 392
- WO-A1-2015/033955
- WO-A1-2018/230370
- JP-A- 2010 137 562
- JP-A- 2013 508 491
- JP-A- 2015 189 823
- JP-A- 2016 098 301
- JP-A- 2018 080 292
- JP-A- H08 283 456
- "Boron nitride that hasa card-house structure", CERAMICS, vol. 51, no. 10, 1 October 2016 (2016-10-01), JP , pages 717 - 718, XP009531006, ISSN: 0009-031X

## Description

### TECHNICAL FIELD

The present invention relates to a thermally conductive resin sheet, a laminated heat dissipation sheet having a metal plate material laminated on the thermally conductive resin sheet, and a heat dissipation circuit board having a conductive circuit laminated thereon.

### BACKGROUND ART

In recent years, power semiconductor devices used in various fields such as railroads, automobiles, industrial applications, and general home appliances have been shifting from conventional Si power semiconductors to power semiconductors using SiC, AlN, GaN, and the like in order to further achieve downsizing, cost reduction, and high efficiency.

The power semiconductor devices are generally used as power semiconductor modules in which a plurality of semiconductor devices are arranged on a common heat sink and packaged together.

Various problems have been pointed out upon the practical use of such power semiconductor devices, and one of the problems is heat generation from the devices. The power semiconductor devices can be operated at high temperatures to achieve high output and high implementation density, but there is a concern that the heat generated by device switching may reduce the reliability of the power semiconductor devices.

In recent years, especially in the electric and electronic fields, heat generation due to high implementation density of integrated circuits has become a major problem, and how to dissipate the heat has become an urgent issue. As one method for solving this problem, ceramic substrates having high thermal conductivity such as alumina substrates and aluminum nitride substrates are used as heat dissipation substrates on which a power semiconductor device is mounted. However, the ceramic substrates have the disadvantages of being easily broken by impact, and being difficult to thin film and downsize.

Therefore, heat dissipation sheets using a thermosetting resin such as an epoxy resin and an inorganic filler have been proposed. For example, Patent Document 1 proposes a heat dissipation resin sheet containing an epoxy resin with a Tg of 60°C or lower and boron nitride, wherein the content of the boron nitride is 30% by volume or more and 60% by volume or less.

Patent Document 2 proposes a film for a metal substrate, which contains an inorganic filler having an average long diameter of 1 to 50 um relative to a polyether ketone-based resin.

Patent Document 3 proposes a heat-resistant thermally conductive packing containing polyether-ether-ketone (PEEK) filled with a thermally conductive filler.

Further, Patent Document 4 proposes a polymer composition in which one or more oxides and nitrides each having an electronegativity in a specific range are added to a semi-crystalline polymer.

On the other hand, Patent Document 5 proposes an inorganic-organic composite material having a structure in which boron nitride particles serving as a highly thermally conductive filler are dispersed in a resin serving as a matrix, wherein the boron nitride particles are dispersed in the resin in a state of "exfoliated flat particles" generated by a step of delaminating secondary particles that are stacked primary particles.

Patent Document 6 (WO 2018/230370) relates to a moldable thermoplastic resin (A) contains, in the structure of the main chain, a biphenyl group-containing unit (i), a substituted biphenyl group-containing unit (ii), a unit (iii) having a specific number of main chain atoms, and a unit (iv) having a specific number of main chain atoms.

Patent Document 7 (JP 2018-080292 A) relates to a resin composition containing a moldable thermoplastic resin having a melting point of 275°C or higher or a load deflection temperature of 150°C or higher, sintered tetrafluoropolyethylene particles and inorganic particles.

Patent Document 8 (EP 3 221 392 A) relates to a polymer composition containing: 30 to 60 volume% of a melt processable fluoropolymer; and 40 to 70 volume% of boron nitride particles.

### CITATION LIST

### PATENT DOCUMENT

Patent Document 1: Japanese Patent Laid-Open No. 2017-036415
Patent Document 2: Japanese Patent Laid-Open No. H03-20354
Patent Document 3: Japanese Patent Laid-Open No. H07-157569
Patent Document 4: Japanese Translation of PCT International Application No. 2008-524362
Patent Document 5: Japanese Patent Laid-Open No. 2012-255055
Patent Document 6: WO2018/230370
Patent Document 7: JP 2018-080292A
Patent Document 8: EP 3 221 392 A

### SUMMARY OF THE INVENTION

### PROBLEM TO BE SOLVED BY THE INVENTION

One of the steps for assembling power semiconductor modules includes a reflow step. In the reflow step, solder is melted by rapidly raising the temperature of the members to join the metal members together. In recent years, the operating temperature of the power semiconductor devices has risen with the increase in output and implementation density. Thus, the heat resistance is also required for the solder used in the reflow step, and high temperature solder requiring a reflow soldering temperature of 290°C is generally used.
Therefore, in the reflow step, the process of raising the temperature to around 290°C at which the high temperature solder melt flows and then cooling is repeated.

When the power semiconductor devices are mounted on the module, heating and cooling are also repeated in the same way.

When using a circuit board having a metal plate or the like bonded to a conventional heat dissipation resin sheet, thermal expansion and contraction may occur due to repeated temperature changes in the reflow step or the like. Then, the difference in the coefficient of linear expansion between the resin sheet and the metal plate causes interface peeling between the heat dissipation resin sheet and the metal plate, and the performance of the power semiconductor module may be deteriorated.

In addition, the performance of the power semiconductor module may be further deteriorated since the members absorb moisture during storage before the reflow step, which greatly accelerates the deterioration of the members during the reflow step.

Further, the conventional heat dissipation resin sheet may not have sufficient withstand voltage performance for power semiconductor device applications in which a large current flows at a high voltage.

Therefore, the present invention has an object to provide a thermally conductive resin sheet having sufficient withstand voltage performance and excellent moisture absorption reflow tolerance.

In the present specification, the term "moisture absorption reflow tolerance" means that the thermally conductive resin sheet, as a laminate with metal plates, has high withstand voltage performance, and does not cause deformation due to interface peeling with the metal plates and foaming of the thermally conductive resin sheet, even after performing a moisture absorption reflow test in which a reflow test (e.g., at 290°C) is performed after storage under high temperature and high humidity conditions (e.g., at 85°C and 85% RH for 3 days).

### MEANS FOR SOLVING PROBLEM

The thermally conductive resin sheet according to one embodiment of the present invention comprises a resin composition containing a crystalline thermoplastic resin having a melting point of 300°C or higher and a thermally conductive filler comprising boron nitride agglomerated particles, wherein the crystalline thermoplastic resin comprises a polyetherketone-based resin.

### EFFECT OF THE INVENTION

The thermally conductive resin sheet of the present invention has sufficient withstand voltage performance and excellent moisture absorption reflow tolerance.

### BRIEF DESCRIPTION OF DRAWINGS

FIG. 1 is a cross-sectional SEM image according to an example of embodiments of the present invention.
FIG. 2 is a schematic diagram according to another example of embodiments of the present invention.
FIG. 3 is a cross-sectional SEM image according to another example of embodiments of the present invention.

### MODE(S) FOR CARRYING OUT THE INVENTION

Hereinafter, embodiments of the present invention will be described in detail. However, the present invention is not limited to the following embodiments, and can be variously modified and implemented within the scope of the gist thereof.

### <Summary of The Present Invention>

First, the summary of the present invention will be described.

As described above, heat dissipation substrates using conventional ceramic materials have problems of being easily broken by impact, and being difficult to thin film and downsize.

It is also known that the thermal conductivity of general ceramic substrates decreases as the temperature rises (see "Manufacturer's Certification" by NETZSCH (certificate of "Pyroceram 9696" calibration sample for xenon flash method measurements according to ASTM-E1416)). Therefore, there is a concern that high thermal conductivity cannot be achieved when ceramic substrates are used for circuit board using in power semiconductor devices, whose operating temperatures have been increasing in recent years.

In order to solve the above-mentioned problems of ceramic materials, a heat dissipation sheet using a thermosetting resin such as an epoxy resin and an inorganic filler is proposed (Patent Document 1).

However, when such a heat dissipation sheet using a thermosetting resin is laminated with metal plates, there are problems that thermal expansion and contraction occur due to temperature changes during the reflow step and at the use of power semiconductor devices, resulting in interface peeling and insufficient withstand voltage performance.

In order to improve the interface peeling, it has been studied to increase the strength of the resin cured product by increasing the degree of crosslinking of the epoxy resin. However, in order to increase the degree of crosslinking of the epoxy resin, it is necessary to increase the number of epoxy functional groups per unit molecular weight, and if so, a hydroxyl group concentration is increased by the addition reaction between the epoxy groups of the epoxy resin and an active hydrogen, which increases the moisture absorption ratio of the epoxy resin. When the moisture absorption ratio of the epoxy resin increases, the insulating property of the resin cured product decreases, and the withstand voltage performance under high temperature and high humidity conditions also decreases. Therefore, it has been considered undesirable to use such a resin as a thermally conductive sheet for power semiconductor devices.

It has also been studied to use an epoxy resin monomer having a rigid molecular structure or to use a thermosetting polyimide resin for increasing the heat resistance of the resin cured product and reducing the coefficient of linear expansion. However, there are problems that the above-mentioned resins require curing conditions of high temperature and long curing time, the resin cured product becomes brittle, and it is difficult to add a large amount of an inorganic filler in order to obtain high thermal conductivity.

Therefore, in order to solve the problems of the thermosetting resins, heat dissipation sheets using thermoplastic resins have also been studied (Patent Documents 2 to 4).

In Patent Document 2, a glass powder or the like is used as the inorganic filler, but the thermal conductivity of glass particles is generally less than 1 W/m·K. Accordingly, it is considered difficult to obtain high thermal conductivity even by adding a large amount of glass particles to a polyether ketone-based resin.

In addition, Patent Document 3 describes that spherical alumina is suitable as the thermally conductive filler, but the thermal conductivity in Examples where spherical alumina is added to a polyether ether ketone resin is 1.5 W/m·K. Accordingly, it is considered difficult to obtain higher thermal conductivity by this technology.

Further, in Patent Document 4, polycarbonate and the like are used as examples of semi-crystalline polymers, but the glass transition temperature of general polycarbonate-based resins is 150°C. Therefore, it is considered that resistance in the reflow step where the temperature reaches 290°C is not assumed.

On the other hand, thermally conductive fillers to be combined with resins has been studied in order to increase the thermal conductivity of heat dissipation sheets (Patent Document 5).

In Patent Document 5, high thermal conductivity is achieved by using specially treated boron nitride particles. However, polycarbonate, epoxy resins, and the like are used as examples of resins, and the problem of moisture absorption reflow tolerance has not been solved with these resins.

Therefore, the present inventors have studied various types of resins and thermally conductive fillers used for a thermally conductive resin sheet, and have found that a thermally conductive resin sheet having excellent moisture absorption reflow tolerance can be obtained.

The thermally conductive resin sheet of the present invention, and the laminated heat dissipation sheet and the heat dissipation circuit board using the thermally conductive resin sheet can be suitably used as heat dissipation sheets for power semiconductor devices, to realize a highly reliable power semiconductor module.

In addition, the thermally conductive resin sheet of the present invention does not require high temperature and long-term curing conditions unlike thermosetting resins, and thus can be easily produced.

### <Configuration of The Present Invention>

Next, the configuration of the present invention will be described.

### 1. Resin Composition

The thermally conductive resin sheet of the present invention comprises a resin composition containing a crystalline thermoplastic resin having a melting point of 300°C or higher, wherein the crystalline thermoplastic resin comprises a polyetherketone-based resin, and a thermally conductive filler.

Hereinafter, each component will be described in detail.

### (1) Thermoplastic Resin

It is preferable that the thermoplastic resin used for the thermally conductive resin sheet does not cause any trouble even at 290°C for 5 minutes, which is the reflow condition for the heat dissipation circuit board. To meet this requirement, it is preferable to use an amorphous thermoplastic resin having a glass transition temperature (Tg) of at least 300°C or higher, or a crystalline thermoplastic resin having a melting point (Tm) of at least 300°C or higher.

In the present invention, the "amorphous thermoplastic resin" refers to a thermoplastic resin having no melting point. On the other hand, the "crystalline thermoplastic resin" refers to a thermoplastic resin having a melting point.

Examples of the heat-resistant amorphous thermoplastic resins available as commercial raw materials include a polycarbonate resin (Tg: 152°C), a modified polyphenylene ether resin (Tg: 211°C), a polysulfone resin (Tg: 190°C), a polyphenylsulfone resin (Tg: 220°C), a polyethersulfone resin (Tg: 225°C), and a polyetherimide resin (Tg: 217°C).

However, all of these commercially available heat-resistant amorphous thermoplastic resins fall far short of resins having a glass transition temperature of 300°C or higher.

A thermoplastic polyimide resin having a glass transition temperature of 300°C or higher is also commercially available. However, the thermoplastic polyimide resin has a very high moldable temperature and a very high melt viscosity at the moldable temperature, and it is thus difficult to fill a large amount of the thermally conductive filler. In addition, since the resin has an imide group in the molecular structure and has high hygroscopicity, it is not preferable to use it as the main component of the thermoplastic resin of the present invention.

Based on the above, the thermoplastic resin used as the matrix resin, which is a main component of the thermoplastic resin, in the present invention is a crystalline thermoplastic resin having a melting point of 300°C or higher.

The melting point of the crystalline thermoplastic resin can be measured by the method specified in ISO 1183. Specifically, it can be determined from the crystal melting peak temperature at the time of secondary temperature rise when the crystalline thermoplastic resin is measured by a differential scanning calorimetry (DSC). For the crystalline thermoplastic resin in the present invention, a resin having at least a clearly visible endothermic peak caused by crystal melting and a peak top temperature of 300°C or higher can be used.

Even when the resin composition to which a thermally conductive filler is added is measured by a differential scanning calorimeter (DSC), there is no large difference in melting point except when the addition of the thermally conductive filler accelerates the deterioration of the matrix resin during heat molding.

The melting point of the crystalline thermoplastic resin in the present invention is preferably 310°C or higher, more preferably 320°C or higher, and even more preferably 330°C or higher, from the viewpoint of moisture absorption reflow tolerance at 290°C. The upper limit of the melting point is not particularly limited. From the viewpoint of molding processability and productivity, it is preferably 380°C or lower, more preferably 370°C or lower, and even more preferably 360°C or lower.

When the melting point is less than 300°C, the elastic modulus of the resin raw material decreases during the moisture absorption reflow at 290°C, resulting in flow deformation of the resin or restoration of elastic strain in the resin layer. Thus, the surface appearance of the thermally conductive resin sheet may be deteriorated, the thickness of the thermally conductive resin sheet may be uneven, and sufficient adhesion strength to the metal substrate may not be obtained.

In addition, there is a risk of foaming in the thermally conductive resin sheet due to the expansion of moisture absorbed by the resin composition in a moist heat environment. When foaming occurs inside the thermally conductive resin sheet, the dielectric breakdown voltage may be reduced significantly. In the case where a heat dissipation metal material is laminated on one surface of the thermally conductive resin sheet, when foaming occurs in the vicinity of the interface between the heat dissipation metal material and the thermally conductive resin sheet, the heat dissipation metal material may be peeled off to significantly reduce the thermal conductivity. In the case where a conductive circuit pattern is formed on the other surface of the thermally conductive resin sheet, when foaming occurs in the vicinity of the interface between the conductive circuit pattern and the thermally conductive resin sheet, the conductive circuit pattern may be peeled off or dropped off, resulting in troubles in the electric circuit or a significant decrease in the thermal conductivity of the thermally conductive resin sheet.

Specific examples of heat-resistant crystalline thermoplastic resins include a polybutylene terephthalate resin (PBT, melting point: 224°C), polyamide 6 (nylon 6, melting point: 225°C), polyamide 66 (nylon 66, melting point: 265°C), a liquid crystal polymer (LCP, melting point: 320°C to 344°C), a polyetherketone-based resin (melting point: 303°C to 400°C), a polytetrafluoroethylene resin (PTFE, melting point: 327°C), an ethylene tetrafluoride·perfluoroalkoxyethylene copolymer resin (PFA, melting point: 302°C to 310°C), and an ethylene tetrafluoride·propylene hexafluoride copolymer resin (FEP, melting point: 250°C to 290°C) .

Among them, the crystalline thermoplastic resin used in the present invention includes a polyetherketone-based resinfrom the viewpoint of having a melting point of 300°C or higher and moldability.

Further, among the above, a polyetherketone-based resin is also used from the viewpoint of adhesiveness with a heat dissipation metal material such as a copper plate.

The polyetherketone-based resin that is used in the present invention is a general term for thermoplastic resins having repeating units represented by formula (1) (m and n in the formula are 1 or 2).

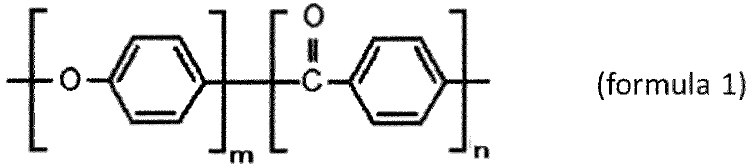

Examples of the polyetherketone-based resin include polyetherketone (PEK; m = 1 and n = 1, melting point 373°C), polyether-ether-ketone (PEEK; m = 2 and n = 1, melting point 343°C), polyether-ketone-ketone (PEKK; m = 1 and n = 2, melting point 303°C to 400°C), polyether-ether-ketone-ketone (PEEKK; m = 2 and n = 2, melting point 358°C), and polyether-ketone-ether-ketone-ketone (PEKEKK; a copolymer containing both a constituent unit of m = 1 and n = 1 and a constituent unit of m = 1 and n = 2, melting point 387°C). Any of these are available as commercial raw materials.

Among the polyetherketone-based resins, polyether-ether-ketone (PEEK) can be particularly preferably used in comprehensive consideration of the following points: the melting point is sufficiently high and the molding process temperature is relatively low to shorten the molding cycle; the continuous heat-resistant temperature is 200°C or higher, and it has been proven that it can be used for heat-resistant applications without any problem; various grades are available in terms of melt viscosity related to the molding processability; it has the most chemically stable structure among the polyetherketone resins, and has excellent hot-water resistance and chemical resistance; and the price is becoming reasonable owing to its wide range of applications.

When polyether-ether-ketone (PEEK) is used as the crystalline thermoplastic resin of the present invention, it may be blended with other thermoplastic resins. The types of other thermoplastic resins are not particularly limited. Among the other thermoplastic resins, a compatible-type resin having an effect of compensating for insufficient performance resulted when only polyether-ether-ketone is used for the applications of the present invention is preferred.

When blended with other thermoplastic resins, it suffices that the blended resin has a melting point of 300°C or higher.

The compatible-type resin is preferably polyetherimide (PEI). By combining PEEK and PEI, not only the crystallinity (crystal melting calorie) of PEEK can be adjusted, but also the glass transition temperature when the resin composition is in an amorphous state can be increased along with the adjustment of the crystallization rate of PEEK (Tg of PEEK is 143°C, while Tg of PEI is 217°C). Since PEI is an amorphous resin, the melting point of the resin itself does not change even if PEEK and PEI are combined.

In addition, in the present invention, the use of PEI, which has an imide group and is amorphous, enables the adhesion to a heat dissipation metal material such as a copper plate to be improved.

The amount of PEI added is preferably 50% by mass or less, with the total amount of the resin composition being 100% by mass. By setting the amount of PEI added to 50% by mass or less, the adhesion to a heat dissipation metal material can be improved while maintaining the heat resistance in the moisture absorption reflow test by the crystallinity of PEEK.

Various commercially available products can be used as PEEK. For example, those having various melt viscosities can be obtained from each company, such as "KetaSpire (registered trademark)" manufactured by Solbay S.A., "VESTAKEEP (registered trademark)" manufactured by Daicel-Evonik Ltd., and "VICTREX PEEK" manufactured by Victrex plc.

These PEEK raw materials may be used as a single grade, or by blending a plurality of grades having different melt viscosities.

The melt viscosity of the crystalline thermoplastic resin in the present invention is not particularly limited. Above all, it is preferably 0.60 kPa·s or less, and more preferably 0.30 kPa·s or less, in order to blend a relatively large amount of the thermally conductive filler to facilitate a heat-molding process. When the melt viscosity falls within the above range, the temperature of the molding apparatus does not need to be excessively high, and deterioration of the raw materials can be suppressed. The lower limit of the melt viscosity is not particularly limited. Above all, it is preferably 0.01 kPa·s or more.

Here, the melt viscosity is in accordance with ASTM D3835, and is a value measured under the conditions of a shear rate of 1,000 s⁻¹ and a temperature of 400°C.

The mass average molecular weight (Mw) of the crystalline thermoplastic resin is preferably 48,000 or more, more preferably 49,000 or more, and even more preferably 50,000 or more, from the viewpoint of long-term durability in a heating environment. In addition, from the viewpoint of molding processability, it is preferably 120,000 or less, more preferably 110,000 or less, and even more preferably 100,000 or less.

The MFR of the crystalline thermoplastic resin is preferably 8 g/10 minutes or more, more preferably 9 g/10 minutes or more, and even more preferably 10 g/10 minutes or more, from the view point of molding processability and difficulty in forming voids between the resin and the added thermally conductive filler. In addition, from the viewpoint of long-term durability in a heating environment, it is preferably 180 g/10 minutes or less, more preferably 170 g/10 minutes or less, and even more preferably 160 g/10 minutes or less.

Here, the MFR is a value measured at 380°C and 5 kgf in accordance with JIS K7210 (2014).

### (2) Thermally Conductive Filler

The thermally conductive resin sheet of the present invention preferably contains an electrically insulating thermally conductive filler in order to improve thermal conductivity, suppress the coefficient of linear expansion, and secure insulating performance.

By suppressing the coefficient of linear expansion of the thermally conductive resin sheet of the present invention, for example, in a configuration in which the thermally conductive resin sheet of the present invention is laminated and integrated with a different material such as a copper plate, the interface peeling between the thermally conductive resin sheet and the different material can be suppressed even when the temperature repeatedly changes between a low temperature (e.g., -40°C) and a high temperature (e.g., 200°C).

In the present invention, the thermally conductive filler refers to particles having a thermal conductivity of 1.0 W/m·K or more, preferably 1.2 W/m·K or more. The thermally conductive filler according to the present invention comprises boron nitride agglomerated particles.

Examples of the thermally conductive filler include an electrically insulating filler composed only of carbon; a metal carbide or semi-metal carbide; a metal oxide or semi-metal oxide; and a metal nitride or semi-metal nitride.

Examples of the electrically insulating filler composed only of carbon include diamond (thermal conductivity: approximately 2,000 W/m·K).

Examples of the metal carbide or semi-metal carbide include silicon carbide (thermal conductivity: approximately 60 to 270 W/m-K), titanium carbide (thermal conductivity: approximately 21 W/m-K), and tungsten carbide (thermal conductivity: approximately 120 W/m·K).

Examples of the metal oxide or semi-metal oxide include magnesium oxide (thermal conductivity: approximately 40 W/m·K), aluminum oxide (thermal conductivity: approximately 20 to 35 W/m·K), silicon oxide (thermal conductivity: approximately 1.2 W/m·K), zinc oxide (thermal conductivity: approximately 54 W/m·K), yttrium oxide (thermal conductivity: approximately 27 W/m·K), zirconium oxide (thermal conductivity: approximately 3 W/m-K), ytterbium oxide (thermal conductivity: approximately 38.5 W/m·K ), beryllium oxide (thermal conductivity: approximately 250 W/m·K), and "SiAlON" (ceramics composed of silicon, aluminum, oxygen, and nitrogen, thermal conductivity: approximately 21 W/m·K).

Examples of the metal nitride or semi-metal nitride include boron nitride (thermal conductivity of plate-shaped particles of hexagonal boron nitride (h-BN) in the surface direction: approximately 200 to 500 W/m·K), aluminum nitride (thermal conductivity: approximately 160 to 285 W/m-K), and silicon nitride (thermal conductivity: approximately 30 to 80 W/m·K).

These thermally conductive fillers may be used singly or in combination of two or more types thereof.

When the thermally conductive resin sheet of the present invention is used for power semiconductor device applications, it is preferable to adopt an inorganic compound having excellent insulating properties since electrical insulation is required. From such a viewpoint, the volume resistivity of the thermally conductive filler at 20°C is preferably 10¹³ Ω·cm or more, and particularly preferably 10¹⁴ Ω·cm or more.

Among them, a metal oxide, a semi-metal oxide, and a metal nitride or semi-metal nitride are preferred from the viewpoint that the electrical insulation of the thermally conductive resin sheet can be easily made sufficient. Specific examples of such a thermally conductive filler include aluminum oxide (Al₂O₃, volume resistivity: > 10¹⁴ Ω·cm), aluminum nitride (AlN, volume resistivity: > 10¹⁴ Ω·cm), boron nitride (BN, volume resistivity: > 10¹⁴ Ω·cm), silicon nitride (Si₃N₄, volume resistivity: > 10¹⁴ Ω·cm), and silica (SiO₂, volume resistivity: > 10¹⁴ Ω·cm).

Among them, aluminum oxide, aluminum nitride, boron nitride, and silica are preferred, and from the viewpoint of imparting high insulating properties to the thermally conductive resin sheet, aluminum oxide and boron nitride are more preferred.

Among them, boron nitride is contained in the thermally conductive filler of the present invention from the viewpoint that there are few problems with moisture absorption during heat-molding, the toxicity is low, the thermal conductivity can be efficiently increased, and high insulation can be imparted to the thermally conductive resin sheet.

The boron nitride preferably contains boron nitride agglomerated particles formed by aggregating primary particles of the boron nitride as a main component. The "containing boron nitride agglomerated particles as a main component" means that the boron nitride agglomerated particles occupy 50% by mass or more of the boron nitride, among which 70% by mass or more, among which 80% by mass or more, and among which 90% by mass or more (including 1000 by mass).

The boron nitride may be used in combination with other thermally conductive fillers. However, the heat transfer behavior in the thermally conductive resin sheet does not simply depend only on the thermal conductivity inside the thermally conductive filler, as described later. Among the particles exemplified above, even if diamond particles or the like, which have extremely high thermal conductivity and are also extremely expensive, are used, the thermal conductivity of the thermally conductive resin sheet in the thickness direction does not increase extremely. Therefore, when boron nitride and other thermally conductive fillers are used in combination, the main focus is on cost cutting for the composition. From the viewpoint of being relatively inexpensive and having relatively high thermal conductivity, it is preferable to appropriately select from magnesium oxide, aluminum oxide, tungsten carbide, silicon carbide, aluminum nitride, and the like as the thermally conductive filler used in combination with boron nitride.

The shape of the thermally conductive filler may be indeterminate form particles, spherical, whisker, fibrous, plate, aggregate, or a mixture thereof.

Among them, the shape of the thermally conductive filler of the present invention is preferably spherical. The "spherical" usually means that the aspect ratio (ratio of long diameter to short diameter) is 1 or more and 2 or less, preferably 1 or more and 1.75 or less, more preferably 1 or more and 1.5 or less, and even more preferably 1 or more and 1.4 or less.

The aspect ratio can be obtained by arbitrarily selecting 200 or more particles from the cross-sectional image of the thermally conductive resin sheet taken by SEM, and calculating the ratio of the long diameter to short diameter of each of the particles to determine the average value.

The thermally conductive filler of the present invention contains boron nitride agglomerated particles (also referred to as "secondary particles") formed by aggregating flat plate-shaped boron nitride particles (also referred to as "primary particles").

Examples of the primary particles include cubic boron nitride and hexagonal boron nitride (h-BN). Among them, hexagonal boron nitride is preferred from the viewpoint of improving thermal conductivity.

Hexagonal boron nitride particles have a shape called a flat plate or a scaly shape, and have a characteristic of very high thermal conductivity in the flat plate surface direction (approximately 200 to 500 W/m·K). However, because of this shape, when a resin sheet is prepared by a general thermoplastic resin molding method (for example, sheet extrusion using an extruder equipped with twin screws, and a T-die), most of the added boron nitride is oriented parallel to the surface of the resin sheet. As a result, the thermal conductivity in the thickness direction of the resin sheet may be lower than that when a spherical filler having the same degree of thermal conductivity is added. Therefore, when the flat plate-shaped primary particles oriented in the direction parallel to the thickness direction are agglomerated to break the surface orientation, the thermal conductivity in the thickness direction is improved.

Examples of the agglomerated structure of the boron nitride agglomerated particles include a cabbage structure and a card-house structure. Among them, the card-house structure is preferred from the viewpoint of improving thermal conductivity.

The aggregate structure of the boron nitride agglomerated particles can be confirmed by a scanning electron microscope (SEM).

The cabbage structure refers to a structure in which flat plate-shaped primary particles are collected and agglomerated into a spherical shape, like the structure of a cabbage. When the agglomerated particles having the cabbage structure are added to the resin sheet, the thermal conductivity in the thickness direction of the sheet can also be easily increased compared to the case where the boron nitride primary particles are simply added, since the boron nitride primary particles constituting the boron nitride agglomerated particles are not oriented only in the surface direction of the thermally conductive resin sheet. However, when viewed in the radial direction from the substantially central portion of the agglomerated particles having the cabbage structure, most of the primary particles are oriented on the flat plate surface perpendicularly to the radial direction. Therefore, some of the primary particles are certainly oriented in the thickness direction of the sheet or oriented closer to the thickness direction, but only a limited number of the particles can effectively conduct heat in the thickness direction.

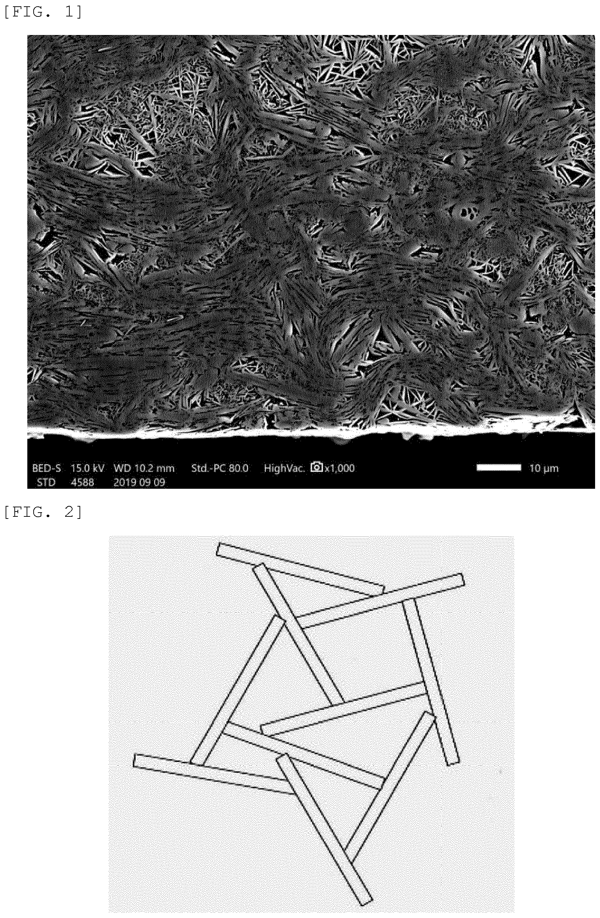

FIG. 1 shows a cross-sectional SEM image of boron nitride agglomerated particles having a cabbage structure added to a thermoplastic resin and heat-press molded. Referring to FIG. 1, it can be seen that many boron nitride primary particles are oriented at shallow angles to the surface direction of the resin sheet.

On the other hand, the card-house structure is a structure in which plate-shaped particles are intricately jointed without orientation, and is described in "Ceramics 43, No. 2" (published by the Ceramic Society of Japan in 2008). More specifically, it refers to a structure in which the planar portion of the primary particles forming the agglomerated particles is in contact with the end face portion of the other primary particles present in the agglomerated particles. FIG. 2 shows a schematic diagram of the card-house structure.

The agglomerated particles having the card-house structure have extremely high strength for fracture owing to their structure, and do not break even in the pressurizing step performed at the time of forming the heat dissipation resin sheet. Therefore, the primary particles, which are usually oriented in the longitudinal direction of the heat dissipation resin sheet, can be present in random directions. Consequently, high thermal conductivity can be achieved not only in the longitudinal direction of the heat dissipation resin sheet but also in the thickness direction.

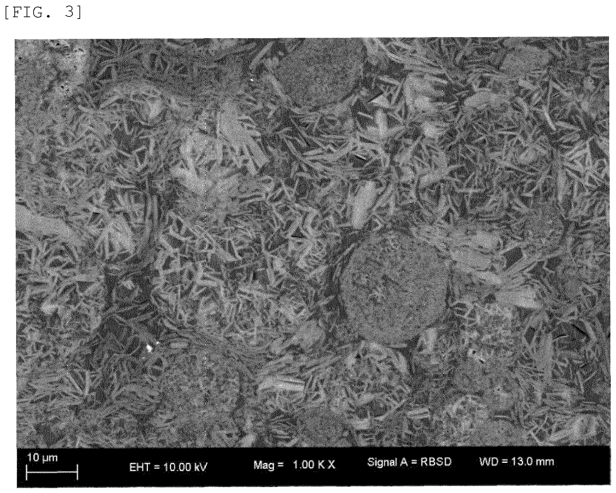

FIG. 3 shows a cross-sectional SEM image of boron nitride agglomerated particles having a card-house structure added to a thermoplastic resin and heat-press molded. It can be seen that more particles are oriented at shallow angles to the thickness direction of the thermally conductive resin sheet, compared to FIG. 1 in which the same mass of the boron nitride agglomerated particles having a cabbage structure is added. Thus, the boron nitride agglomerated particles having a card-house structure have more primary particles oriented in the thickness direction than those having a cabbage structure, so that thermal conduction can be effectively performed in the thickness direction, and the thermal conductivity can be further increased in the thickness direction.

The boron nitride agglomerated particles having a card-house structure can be produced, for example, by the method described in International Publication No. 2015/119198.

When using the boron nitride agglomerated particles having a card-house structure, the particles can be surface-treated with a surface treatment agent. As an example of the surface treatment agent, a known surface treatment agent such as a silane coupling agent can be used. In general, there are many cases where direct affinity and adhesion are not observed between the thermally conductive filler and the thermoplastic resin, and this is the same to the case of using the boron nitride agglomerated particles having a card-house structure as the thermally conductive filler. It is considered that the thermal conductivity attenuation at the interface can be further reduced by increasing the adhesion at the interface between the thermally conductive filler and the matrix resin by chemical treatment.

The use of the boron nitride agglomerated particles as the thermally conductive filler of the present invention enables the particle diameter to be further increased, compared to the thermally conductive filler using the primary particles as they are. When the particle diameter of the thermally conductive filler is increased, the number of the heat transfer paths between the thermoplastic resin having low thermal conductivity and the thermally conductive filler can be reduced, and thus the increase in thermal resistance in the heat transfer path in the thickness direction can be suppressed.

From the above viewpoint, the lower limit of the maximum particle diameter Dmax on the volume basis of the thermally conductive filler (hereinafter also referred to as "maximum particle diameter") is preferably 20 um or more, more preferably 30 um or more, and even more preferably 50 um or more. Meanwhile, the upper limit of the maximum particle diameter Dmax is preferably 300 µm or less, more preferably 200 um or less, even more preferably 100 um or less, and still more preferably 90 um or less.

The lower limit of the average particle diameter D50 on the volume basis of the thermally conductive filler is preferably 2 um or more, more preferably 5 um or more, even more preferably 10 um or more, and still more preferably 20 um or more. Meanwhile, the upper limit of the average particle diameter D50 is preferably 300 um or less, more preferably 200 um or less, even more preferably 100 um or less, and still more preferably 80 um or less.

When the maximum particle diameter of the thermally conductive filler is equal to or less than the above upper limit, the interface between the matrix resin and the thermally conductive filler is reduced when the thermally conductive filler is contained in the matrix resin. As a result, the thermal resistance is reduced, high thermal conductivity can be achieved, and a good quality sheet free from surface roughness or the like can be formed. When the maximum particle dimeter is equal to or more than the above lower limit, a sufficient effect of improving thermal conductivity can be obtained as the thermally conductive filler required for circuit board using in power semiconductor devices.

It is considered that when the size of the thermally conductive filler is 1/10 or less of the thickness of the thermally conductive resin sheet, the influence of the thermal resistance at the interface between the matrix resin and the thermally conductive filler on the thickness of the thermally conductive resin sheet is remarkable. In particular, thermally conductive resin sheets having a thickness of 100 to 300 um are often applied for circuit board using in power semiconductor devices, and thus, from the viewpoint of thermal conductivity, the maximum particle diameter Dmax on the volume basis of the thermally conductive filler is preferably larger than the above lower limit.

In addition, when the maximum particle diameter Dmax of the thermally conductive filler is equal to or more than the lower limit, not only the thermal conductivity attenuation caused by the interface between the thermally conductive filler and the matrix resin is suppressed, but also the number of required thermal conduction paths between the particles is reduced, and the probability of connecting from one surface to the other in the thickness direction of the thermally conductive resin sheet is increased.

Further, when the maximum particle diameter Dmax of the thermally conductive filler is equal to or more than the lower limit, the interface area between the matrix resin and the thermally conductive filler is reduced compared to the case where particles having a Dmax smaller than the above lower limit are used in the same mass. Therefore, the generation of voids that tend to occur at the interface between the matrix resin and the thermally conductive filler can be suppressed in the thermally conductive resin sheet, and excellent withstand voltage characteristics can be easily obtained.

Meanwhile, when the maximum particle diameter Dmax on the volume basis of the thermally conductive filler is equal to or less than the above upper limit, the protrusion of the thermally conductive filler on the surface of the thermally conductive resin sheet is suppressed, and a good surface shape free from surface roughness can be obtained. Accordingly, when preparing a sheet bonded to a metal material, it has sufficient adhesion, and excellent withstand voltage characteristics can be obtained.

The ratio of the size (Dmax) of the thermally conductive filler to the thickness of the thermally conductive resin sheet (Dmax/thickness) is preferably 0.3 or more and 1.0 or less, more preferably 0.35 or more or 0.95 or less, and even more preferably 0.4 or more or 0.9 or less.

The maximum particle diameter Dmax and the average particle diameter D50 of the thermally conductive filler can be measured, for example, by the following method.

A sample of thermally conductive filler dispersed in a solvent, specifically a sample of thermally conductive filler dispersed in a pure water medium containing sodium hexametaphosphate as a dispersion stabilizer, is subjected to particle size distribution measurement using a laser diffraction/scattering particle size distribution measuring apparatus LA-920 (manufactured by HORIBA, Ltd.), and the maximum particle diameter Dmax and the average particle diameter D50 of the thermally conductive filler can be determined from the obtained particle size distribution. Alternatively, the maximum particle diameter and the average particle diameter can be determined by a dry-type particle size distribution measuring apparatus such as Morphologi G3 (manufactured by Malvern).

The maximum particle diameter Dmax and the average particle diameter D50 of the thermally conductive filler added to the thermoplastic resin can also be measured in the same way as described above by dissolving and removing the thermoplastic resin in a solvent (including a heating solvent), or by physically removing the thermoplastic resin after swelling it to reduce the strength of adhesion to the thermally conductive filler, and further removing the resin component by heating and ashing under the air.

### (3) Content of Each Component

The lower limit of the content of the thermoplastic resin is preferably 15% by mass or more, and more preferably 20% by mass or more, relative to 100% by mass of the resin composition of the present invention. Meanwhile, the upper limit of the content of the thermoplastic resin is preferably 40% by mass or less, and more preferably 35% by mass or less.

The lower limit of the content of the thermally conductive filler is preferably 60% by mass or more, and more preferably 65% by mass or more, relative to 100% by mass of the resin composition of the present invention. Meanwhile, the upper limit of the content of the thermally conductive filler is preferably 85% by mass or less, and more preferably 80% by mass or less.

When the content of the thermally conductive filler is equal to or more than the above lower limit, the effects of improving the thermal conductivity and controlling the coefficient of linear expansion by the thermally conductive filler are satisfactorily exhibited. Meanwhile, when the content of the thermally conductive filler is equal to or less than the above upper limit, the moldability of the resin composition and the interfacial adhesion to different materials are improved.

In general, the blending ratio of the thermally conductive resin composition is often specified by the volume fraction of each of the matrix resin and the thermally conductive filler (hence, the area ratio in the cross section of the thermally conductive resin sheet). The thermal conductivity of the thermally conductive resin sheet in the thickness direction is not determined only by the volume fraction, but is related to various factors such as the above-mentioned preferred particle size, particle orientation state, and particle shape. Therefore, in the present invention, the mass fraction is used for the convenience of actual compounding.

In particular, when boron nitride agglomerated particles having a card-house structure are used as the thermally conductive filler, the particles are not characterized only by the card-house structure as an internal structure. A large number of flat plate-shaped primary boron nitride particles oriented in the radial direction from the central substantially portion of the agglomerated particles are formed on the surface of the particles in a protruding state, such as a so-called "igaguri (burr-like)" shape or "kompeito (confetti)" shape, and the protrusions of the adjacent card-house structure particles come into physical contact with each other, to thereby form a heat transfer path having low thermal resistance in the thickness direction. Therefore, it may not be easy to determine the volume fraction of each of the matrix resin and the thermally conductive filler by observation with a normal scanning electron microscope (SEM). Furthermore, when the amount of the agglomerated boron nitride having a card-house structure added is increased, the pressure applied during the heat-press-molding of the resin composition deforms the area where the particles are in contact with each other, and it is observed that the particles are in contact with each other in linear contact, that is, in a planar contact, rather than in point contact where the particles are in contact with each other as spherical particles. With such a contact state, efficient thermal conduction paths can be formed by the addition of the boron nitride having a card-house structure. However, even in such a case, it may not be easy to determine the volume fraction of each of the matrix resin and the thermally conductive filler by SEM observation.

The thermally conductive filler of the present invention preferably contains 50% by mass or more of the boron nitride agglomerated particles, more preferably 60% by mass or more, even more preferably 70% by mass or more, and still more preferably 80% by mass or more, relative to 100% by mass of the thermally conductive filler. The total amount (100% by mass) of the thermally conductive filler may only be composed of the boron nitride agglomerated particles.

When the content of the boron nitride agglomerated particles is equal to or more than the above lower limit, the thermal conductivity of the thermally conductive resin sheet in the thickness direction is increased.

The resin composition of the present invention may contain other components in addition to the crystalline thermoplastic resin and the thermally conductive filler. However, from the viewpoint of improving thermal conductivity, it is preferable not to contain other components.

Examples of the other components include phosphorus-based, phenol-based, and other various antioxidants; phenolic acrylate-based and other process stabilizers; thermal stabilizers; hindered amine-based radical scavengers (HAAS); impact modifiers; processing aids; metal inactivating agents; copper damage inhibitors; antistatic agents; flame retardants; additives that improve the affinity of the interface between the thermally conductive filler and the thermoplastic resin, such as a silane coupling agent; additives that can be expected to increase the adhesion strength between the resin sheet and a metal plate-shaped material, such as a silane coupling agent; and extenders. When these additives are used, the amount added may generally be in the range of the amount used for these purposes.

### (4) Particularly Preferred Embodiment

The resin composition according to the present invention contains a crystalline thermoplastic resin having a melting point of 300°C or higher and a thermally conductive filler, wherein the thermally conductive filler contains boron nitride agglomerated particles, wherein the crystalline thermoplastic resin comprises a polyetherketone-based resin.

The resin composition according to another example of the preferred embodiments of the present invention contains 15% by mass or more and 40% by mass or less of a crystalline thermoplastic resin having a melting point of 300°C or higher, and 60% by mass or more and 85% by mass or less of a thermally conductive filler.

### 2. Thermally Conductive Resin Sheet

The thermally conductive resin sheet of the present invention is composed of the resin composition, has excellent moisture absorption reflow tolerance, and is less likely to cause interface peeling due to thermal expansion and contraction when formed into a laminate with metal plates.

The thermal conductivity of the thermally conductive resin sheet in the thickness direction at 25°C is preferably 5.0 W/m·K or more, more preferably 7.0 W/m·K or more, even more preferably 9.0 W/m·K or more, still more preferably 10.0 W/m·K or more, and particularly preferably 15.0 W/m-K or more. When the thermal conductivity in the thickness direction is equal to or more than the above lower limit, the sheet can be suitably used for power semiconductor devices or the like to be operated at high temperatures.

The thermal conductivity can be adjusted by changing the type of the thermoplastic resin and its physical properties such as melt viscosity, the type and content of the thermally conductive filler, the method of mixing the thermoplastic resin and the thermally conductive filler, and the conditions in the heat-kneading step described later.

The thermally conductive resin sheet of the present invention preferably has a thermal conductivity in the thickness direction at 200°C of 90% or more, and more preferably 92% or more, relative to the thermal conductivity in the thickness direction at 25°C. When the thermal conductivity in the thickness direction at 200°C is equal to or more than the above lower limit, the sheet can be suitably used for power semiconductor devices or the like to be operated at high temperatures.

The lower limit of the thickness of the thermally conductive resin sheet is preferably 50 um or more, more preferably 60 um or more, and even more preferably 70 um or more. Meanwhile, the upper limit of the thickness thereof is preferably 300 um or less, more preferably 200 um or less, and even more preferably 160 um or less. By setting the thickness of the thermally conductive resin sheet to 50 um or more, sufficient withstand voltage characteristics can be secured. Meanwhile, by setting the thickness thereof to 300 um or less, miniaturization and thinning can be achieved especially when the thermally conductive resin sheet is used for power semiconductor devices or the like, and the effect of reducing the thermal resistance in the thickness direction by the thinning of the film can be obtained compared to insulating thermally conductive layers made of ceramic materials.

In the thermally conductive resin sheet of the present invention, it is preferable to lower the orientation of the primary particles of the thermally conductive filler in order to reduce the anisotropy of the thermal conductivity and to increase the thermal conductivity in the thickness direction.

The orientation of the primary particles can be evaluated by determining the ratio "I(002)/I(100)", where I(002) is the diffraction peak intensity of the (002) plane and I(100) is the diffraction peak intensity of the (100) plane, when the thermally conductive resin sheet is measured by the X-ray diffraction method.

The ratio "I(002)/I(100)" is preferably 20.0 or less, more preferably 17.0 or less, and even more preferably 15.0 or less. When the ratio is more than 20.0, the thermally conductive filler may be collapsed in the melt-kneading step or excessively crushed in the pressurizing step, and thus the amount of the thermally conductive filler that is parallel to the surface direction of the thermally conductive resin sheet or that has a small angle thereto is increased. In this case, even if the content of the thermally conductive filler is increased, it is difficult to increase the thermal conductivity in the thickness direction.

The lower limit of the above ratio "I(002)/I(100)" is not particularly limited. For example, when boron nitride agglomerated particles having a card-house structure are used as the thermally conductive filler, the ratio "I(002)/I(100)" of the particles alone is approximately 4.5 to 6.6. Therefore, it is considered that 4.5 is the lower limit except when performing an intentional orientation operation.

The orientation of the primary particles of the thermally conductive filler is preferably adjusted without any intentional orientation operation from the viewpoint of simplifying the producing process. The orientation thereof can be adjusted, for example, by appropriately changing the type of the thermoplastic resin and its physical properties such as melt viscosity, the type and content of the thermally conductive filler, the method of mixing the thermoplastic resin and the thermally conductive filler, and the conditions in the heat-kneading step described later.

### 3. Method for Producing Thermally Conductive Resin Sheet

Hereinafter, first and second production methods will be described as examples of the method for producing the thermally conductive resin sheet of the present invention. However, the method for producing the thermally conductive resin sheet of the present invention is not limited to these production methods.

### <First Production Method>

The first method for producing a thermally conductive resin sheet of the present invention includes a heat-kneading step in which a crystalline thermoplastic resin having a melting point of 300°C or higher and a thermally conductive filler are heated and kneaded to prepare a resin composition, and a press-molding step in which the resin composition is pressed by a heating body to form a sheet.

### (1) Heat-Kneading Step

In the heat-kneading step, the crystalline thermoplastic resin and the thermally conductive filler are melt-kneaded by heating.

The crystalline thermoplastic resin and the thermally conductive filler can be charged into a processing machine to perform the melt-kneading in the heat-kneading step.

The processing machine used in the heat-kneading step may be those commonly used for the purpose of kneading thermally conductive fillers or various additives into thermoplastic resins. Examples thereof include a continuous kneader, a plastomill kneader, a co-directional twin-screw extruder-type kneader, a cross-directional twin-screw extruder-type kneader, and a single-screw extruder-type kneader.

The melt-kneading temperature, that is, the setting temperature of the processing machine (in the case of an extruder-type melt-kneading machine, the setting temperature of the cylinder heater) is preferably 370°C to 430°C, and more preferably 380°C to 420°C. By setting the melt-kneading temperature to 370°C or higher, the resin viscosity can be sufficiently reduced to suppress the increase in the load on the processing machine. In addition, the thermally conductive filler can be prevented from being sheared and broken during kneading, thereby improving the thermal conductivity of the thermally conductive resin sheet to be obtained. Meanwhile, by setting the melt-kneading temperature to 450°C or lower, the deterioration of the resin itself and the degradation of the physical properties of the molded thermally conductive resin sheet can be suppressed.

### (2) Press-Molding Step

The resin composition of the present invention that has been heat-melted and kneaded often has a lumpy to powdery shape even after undergoing the heat-kneading step since the resin composition contains a large amount of the thermally conductive filler. Thus, it is often difficult to adopt a production method in which the sheet is molded and wound up in a step continuous with the melt-kneading step, as is usually the case with sheet molding of thermoplastic compositions. In the present invention, it is preferable to form the obtained lumpy to powdery-shaped mixture into a sheet by press-molding, which is a batch process. However, the method for producing a thermally conductive resin sheet of the present invention is not limited to batch pressing. It is considered that the sheet can be produced as a continuous sheet if there is a sheeting machine or the like using a steel belt method capable of continuous molding at a certain level of high temperatures and high pressures.

For the press-molding, which is a batch process, various known press machines for molding thermoplastic resins can be used. From the viewpoint of preventing resin deterioration during heat-pressing, it is particularly preferable to use a vacuum press machine capable of reducing the amount of oxygen in the press machine during heating, or a press machine equipped with a nitrogen substitution apparatus.

In the pressing step, it is preferable to set the pressurizing pressure for the purposes of bringing the added thermally conductive fillers into contact with each other to form a heat path, and eliminating voids or gaps in the sheet, in addition to the purpose of forming the melt-kneaded mixture into a sheet body having a uniform thickness. From such a viewpoint, the pressure in the pressing step is usually 8 MPa or more, preferably 9 MPa or more, and more preferably 10 MPa or more, as the actual pressure applied to the sample. Meanwhile, it is preferably 50 MPa or less, more preferably 40 MPa or less, and even more preferably 30 MPa or less. By setting the pressure at the time of pressurization to the above upper limit or less, the thermally conductive filler can be prevented from being crushed, thereby obtaining a thermally conductive resin sheet having high thermal conductivity. Meanwhile, by setting the pressurized pressure to the above lower limit or more, the contact among the thermally conductive fillers is improved to facilitate forming thermal conduction paths, thereby obtaining a sheet having high thermal conductivity. Moreover, the number of voids in the resin sheet can be reduced, thereby obtaining a thermally conductive resin sheet having high dielectric breakdown voltage even after the moisture absorption reflow test.

In the press-molding step, the setting temperature of the resin press machine is preferably 370°C to 440°C, and more preferably 380°C or higher or 420°C or lower.

By performing press-molding at a temperature in this range, good thickness uniformity and high thermal conductivity owing to good contact among the added thermally conductive fillers can be imparted to the thermally conductive resin sheet to be obtained. When the molding temperature is 370°C or higher, the resin viscosity is lowered to a level sufficient for shaping processing, and sufficient thickness uniformity can be imparted to the thermally conductive resin sheet to be molded. Meanwhile, when the setting temperature of the press machine is 440°C or lower, deterioration of the resin itself and the degradation of the physical properties of the molded thermally conductive resin sheet can be suppressed.

The pressurizing time is usually 30 seconds or more, preferably 1 minute or more, more preferably 3 minutes or more, and even more preferably 5 minutes or more. Meanwhile, it is preferably 1 hour or less, more preferably 30 minutes or less, and even more preferably 15 minutes or less. By setting the pressurizing time to the above upper limit or less, the production process time of the thermally conductive resin sheet can be reduced, and the cycle time can be shortened compared to a thermally conductive resin sheet using a heat-resistant thermosetting resin, thereby reducing the production cost. Meanwhile, by setting the pressurizing time to the above lower limit or more, sufficient uniformity in the thickness of the thermally conductive resin sheet can be obtained, and internal voids and gaps can be sufficiently removed to prevent nonuniformity in thermal conduction performance and withstand voltage characteristics.

### <Second Production Method>

The second method for producing a thermally conductive resin sheet of the present invention includes mixing a powder containing a crystalline thermoplastic resin having a melting point of 300°C or higher and a powder containing a thermally conductive filler to produce a resin composition, and pressing the resin composition with a heating body to form a sheet.

In the second production method, the resin composition can be charged into a processing machine, melt-kneaded, and then pressed in the same manner as in the melt-kneading step in the first production method.

On the other hand, from the viewpoint of improving the thermal conductivity of the thermally conductive resin sheet to be obtained, in the second production method, it is preferable to prepare a resin composition by stirring and mixing a powder composed of a thermoplastic resin and a powder of a thermally conductive filler at room temperature without performing the above-mentioned heat-kneading step. By using this method, the thermally conductive filler can be prevented from being sheared and broken during melt-kneading.

When using a boron nitride-containing material, especially a material containing boron nitride agglomerated particles as the thermally conductive filler, the thermally conductive filler may be sheared and broken when melt-kneaded according to the first production method.

On the other hand, in the second production method, the resin composition can be prepared without performing the heat-kneading step, and shear fracture due to melt-kneading can be suppressed, thereby maintaining excellent thermal conductivity of the thermally conductive resin sheet.

From the above viewpoint, the second production method is particularly suitable when using a boron nitride-containing material as the thermally conductive filler, especially a material containing boron nitride agglomerated particles.

A D50 ratio of the powder containing thermally conductive filler to the powder containing crystalline thermoplastic resin is 0.3 to 6.0.

When the ratio (filler/thermoplastic resin) is 0.3 or more, it is considered that the density of the thermally conductive filler can be suppressed from varying in the thermally conductive resin sheet, so that the location unevenness of the thermal conductivity is less likely to occur. Meanwhile, when the ratio (filler/thermoplastic resin) is 6.0 or less, it is considered that the thermally conductive filler can be prevented from being excessively exposed to the surface of the thermally conductive resin sheet, which improves the adhesion strength when the thermally conductive resin sheet is laminated with metal plates and suppresses forming voids at the lamination interface with the metal plates.

In the second production method, from the viewpoint of improving the thermal conductivity and controlling the coefficient of linear expansion, the resin composition preferably contains 60% by mass or more of the powder containing the thermally conductive filler, and more preferably 65% by mass or more, in 100% by mass of the resin composition. Meanwhile, from the viewpoint of moldability and interfacial adhesion with metal materials or the like, the resin composition preferably contains 85% by mass or less of the powder containing the thermally conductive filler, and more preferably 80% by mass or less, in 100% by mass of the resin composition.

The press temperature and press pressure in the second production method may be the same as those in the press-molding step.

### 4. Laminated Heat dissipation sheet

The laminated heat dissipation sheet of the present invention is obtained by laminating a heat dissipation material on one surface of the thermally conductive resin sheet of the present invention.

The heat dissipation material is not particularly limited as long as it is composed a material having good thermal conductivity. Among others, in order to increase the thermal conductivity in the laminated structure, it is preferable to use a heat dissipation metal material, and it is more preferable to use a flat plate-shaped metal material.

The type of the metal material is not particularly limited. Among others, a copper plate, an aluminum plate, an aluminum alloy plate, and the like, which have good thermal conductivity and are relatively inexpensive, are preferred.

When a flat plate-shaped metal material is used as the heat dissipation metal material in the laminated heat dissipation sheet, the thickness of the metal material is preferably 0.03 to 6 mm, and more preferably 0.1 mm or more or 5 mm or less, in order to secure sufficient heat dissipation properties.

As to bonding with the heat dissipation metal material, the surface of the metal material on the side to be laminated with the thermally conductive resin sheet may be subjected to a surface roughening treatment such as soft etching, burn plating, or oxidation-reduction reaction; or to a surface treatment such as plating of various metals and metal alloys to ensure adhesion durability, organic surface treatment including silane coupling treatment such as amino-type and mercapto-type, or surface treatment with organic and inorganic composite materials. These surface treatments can further improve the initial adhesion strength, the durability of the adhesion strength, and the effect of suppressing interface peeling after performing a moisture absorption reflow test.

Meanwhile, the surface of the heat dissipation metal material on the side opposite to the side to be laminated with the thermally conductive resin sheet may not be a simple flat plate, and may be processed to increase the surface area in order to secure the contact area with a cooling medium such as gas or liquid.

Examples of the processing to increase the surface area include: roughening the surface by blasting process or the like to increase the surface area; directly forming V-shaped or rectangular grooves or various shaped unevenness on the heat dissipation metal material by cutting or pressing; bonding another metal material that has been processed to increase the surface area to the heat dissipation metal layer composed of the flat plate-shaped metal material by casting, diffusion bonding, bolting, soldering, brazing, or the like; and embedding metal pins. Further, it is also conceivable to directly press-laminate the thermally conductive resin sheet on a heat dissipation metal layer having a cavity for passing through the cooling medium. However, since the pressurized pressure between the thermally conductive resin sheet and the heat dissipation metal plate is relatively high, it is preferable that the one in which the flat plate-shaped metal material and the thermally conductive resin sheet are laminated and integrated, is then integrated with a groove cut metal plate or a metal layer having a cavity for passing through the cooling medium by soldering, brazing, bolting, or the like, in a later process.

For the laminated integration of the heat dissipation metal material and the thermally conductive resin sheet in the laminated heat dissipation sheet, the press-molding, which is a batch process, can be preferably used. In this case, the press equipment, press conditions, and the like are the same as the range of press-molding conditions for obtaining the above-mentioned thermally conductive resin sheet.

### 5. Heat dissipation Circuit Board

The heat dissipation circuit board of the present invention has the above-mentioned laminated heat dissipation sheet. The heat dissipation circuit board is, for example, provided with a configuration in which a heat dissipation metal material is laminated on one surface of the thermally conductive resin sheet of the present invention. Among others, it is preferable to have a configuration in which, for example, a conductive circuit is laminated on the surface opposite to the surface where the heat dissipation metal material of the thermally conductive resin sheet is laminated, by an etching treatment or the like in a later process.

The heat dissipation circuit board is more preferably integrated with the configuration of "heat dissipation metal material/thermally conductive resin sheet/conductive circuit". Examples of the state before circuit etching include: a state where a conductive circuit-forming metal material having a flat plate-shape is formed on the entire surface of one side of the thermally conductive resin sheet; and a state where the conductive circuit-forming metal material is formed in a partial area thereof, in the integrated configuration of "heat dissipation metal material/thermally conductive resin sheet/conductive circuit-forming metal material".

The type of the conductive circuit-forming metal material is not particularly limited. In general, from the viewpoint of good electrical conductivity, good etching properties, cost, and the like, it is preferably formed of a thin copper plate having a thickness of 0.05 mm or more and 1.2 mm or less.

The dielectric breakdown voltage of the heat dissipation circuit board is preferably 40 kV/mm or more, more preferably 50 kV/mm or more, even more preferably 60 kV/mm or more, and still more preferably 80 kV/mm or more. When the dielectric breakdown voltage is 40 kV/mm or more, a dielectric breakdown voltage of 4 kV or more can be obtained even for a thermally conductive resin sheet having, for example, a thickness of 100 um. When the dielectric breakdown voltage is 80 kV/mm or more, a dielectric breakdown voltage of 4 kV or more can be obtained even for a thermally conductive resin sheet having a thickness of 50 um. Thus, while using a thin thermally conductive resin layer that is advantageous to heat resistance, sufficient withstand voltage performance can be obtained to suppress the occurrence of dielectric breakdown at the time of applying high voltage.

### 6. Power Semiconductor Device

The thermally conductive resin sheet of the present invention can be suitably used as a heat dissipation sheet for power semiconductor devices, and can realize a highly reliable power semiconductor module.

The power semiconductor device uses the thermally conductive resin sheet or the laminated heat dissipation sheet, and mounts the thermally conductive resin sheet or the laminated heat dissipation sheet as a heat dissipation circuit board.

The power semiconductor device is capable of high output and high implementation density with high reliability owing to the heat dissipation effect by high thermal conductivity.

In the power semiconductor device, conventionally known members can be appropriately adopted as the members such as aluminum wirings, sealing materials, packaging materials, heat sinks, thermal pastes, and solders, other than the thermally conductive resin sheet and the laminated heat dissipation sheet.

### <Explanation of Terms and Phrases>

In the case of being expressed as the term "X to Y" (X and Y are arbitrary numbers) in the present description, unless otherwise stated, the term includes the meaning of "preferably more than X" or "preferably less than Y" along with the meaning "X or more and Y or less".

Further, in the case of being expressed as the term "X or more" (X is an arbitrary number) or the term "Y or less" (Y is an arbitrary number), the term also includes the intention of being "preferably more than X" or "preferably less than Y".

In the present invention, the term "sheet" conceptually includes a sheet, a film, and a tape.

### EXAMPLES

Hereinafter, the present invention will be described in more details with reference to Examples. The present invention is not limited to the following Examples unless the gist thereof is exceeded.

### <Examples 1 to 14, Comparative Examples 1 and 2, and Reference Examples 1 and 2>

The materials used and the production method of the thermally conductive sheet in each of Examples 1 to 14, Comparative Examples 1 and 2, and Reference Examples 1 and 2 are as follows.

### [Materials Used]

### (Matrix Resin)

The following materials were used as matrix resins of Examples 1 to 14, Comparative Examples 1 and 2, and Reference Examples 1 and 2.
· Polyether-ether-ketone "VESTAKEEP 1000G" (manufactured by Daicel-Evonik Ltd., melting point: 343°C, melt viscosity: 0.14 kPa·s (400°C), MFR: 158 g/10 minutes, mass average molecular weight (Mw): 52,000)
· Polyether-ether-ketone "KetaSpire KT-880FP" (manufactured by Solvay S.A., melting point: 343°C, melt viscosity: 0.15 kPa·s (400°C), average particle diameter (D50): 30.0 to 45.0 um, MFR: 86 g/10 minutes, mass average molecular weight (Mw): 58,000)
· Homopolybutylene terephthalate "NOVADURAN 5010R" (manufactured by Mitsubishi Engineering-Plastics Corp., melting point: 224°C, melt viscosity: 0.12 kPa·s (300°C), MFR: 16 g/10 minutes (converted value from MVR (cm³/10 minutes) ·250°C·2.16 kg), mass average molecular weight: 88,000)
· Epoxy-based resin composition ((8.74 parts by mass of bisphenol F-type epoxy resin (manufactured by Mitsubishi Chemical Corp., mass average molecular weight in terms of polystyrene: 60,000); 10.93 parts by mass of hydrogenated bisphenol A-type liquid epoxy resin (manufactured by Mitsubishi Chemical Corp.); 2.62 parts by mass of p-aminophenol-type liquid epoxy resin (manufactured by Mitsubishi Chemical Corp.); 5.73 parts by mass of phenol resin-based curing agent "MEH-8000H" (manufactured by Meiwa Plastic Industries, Ltd.); and 0.48 parts by mass of curing catalyst, 1-cyanoethyl-2-undecyl imidazole "C11Z-CN" (manufactured by Shikoku Chemicals Corp., molecular weight: 275))

Here, the melt viscosity of each resin is determined at a shear rate of 1,000 s⁻¹ and a temperature of 400°C in accordance with ASTM D3835. The melt viscosity of homopolybutylene terephthalate is determined at a shear rate of 1,000 s⁻¹ and a temperature of 300°C.

### (Thermally Conductive Filler)

The following materials were used as thermally conductive fillers of Examples 1 to 14, Comparative Examples 1 and 2, and Reference Examples 1 and 2.
· Thermally conductive filler 1: boron nitride agglomerated particles (secondary particles) having a so-called "cabbage" structure in which flat plate-shaped boron nitride particles (primary particles) are collected and agglomerated into a spherical shape, "PTX25" (manufactured by Momentive Inc., average particle diameter (D50): 25 um, specific surface area: 7 m²/g)
· Thermally conductive filler 2: boron nitride agglomerated particles having a card-house structure produced according to International Publication No. 2015/119198 (average particle diameter (D50): 35 um, Dmax: 90 um)
· Thermally conductive filler 3: Flat plate-shaped boron nitride primary particles "AP-10S" (manufactured by Maruka Co., Ltd., average particle diameter (D50): 3.0 um, specific surface area: 10 m²/g)

### [Preparation of Thermally Conductive Resin Sheet]

The types and additive amounts of the matrix resin and the thermally conductive filler were as shown in Tables 1 and 2, and thermally conductive resin sheets were prepared by the following method.

### (Examples 1 to 8 and Reference Example 1)

The matrix resin and the thermally conductive filler were kneaded using a labo plastomill ("4C150", manufactured by Toyo Seiki Seisaku-sho, Ltd.) at 380°C for 5 minutes to obtain a melt-kneaded mixture of the matrix resin and the thermally conductive filler. In Example 5, a melt-kneaded mixture was obtained in the same manner as the above except that the melt-kneading temperature was changed to 395°C.

Here, the above 5 minutes means the period during which the procedures of charging a small amount of the matrix resin into the labo plastomill, confirming that it was plasticized, and then charging a small amount of the thermally conductive filler therein in the same way, were repeated such that the total amount of the mixture of the matrix resin and the thermally conductive filler was 80g, and then the melt-kneading was performed for another 5 minutes after the end of charging the total amount of 80 g of the mixture.

Next, using a high-temperature vacuum press machine (manufactured by KITAGAWA SEIKI Co., Ltd.), the melt-kneaded mixture was pressed at a press temperature of 395°C and at a press surface pressure of 10 MPa for 10 minutes to obtain a thermally conductive resin sheet having a thickness of 150 um in a 15 cm square.

Here, the above 10 minutes means the period during which the melt-kneaded mixture was charged into the vacuum press machine preheated to 150°C as a press-prepared component, a light pressurization of several MPa was applied to the melt-kneaded mixture while operating the vacuum pump, the temperature inside the press machine was set to 395°C to raise the temperature for 40 minutes, the press surface pressure was set to 10 MPa, and then the pressing was performed for another 10 minutes. After an elapse of 10 minutes, the internal temperature of the press machine was again set to 150°C, the vacuum was released when the internal temperature gradually approached 150°C, and the press-prepared component was taken out to obtain a thermally conductive resin sheet.

The above press-prepared component refers to a component necessary for one press by a batch process, in which a metal spacer having a thickness of 6 mm and a frame shape of 20 cm in length and width with an opening of 15 cm × 15 cm in length and width is placed on a lower plating plate having a size of 30 cm in length and width; the melt-kneaded mixture having a mass required for obtaining a press sheet having a thickness of 150 um is sprayed in the spacer; a drop lid having a thickness of 5.85 mm and a length and width of 14.6 cm × 14.6 cm is fitted to the opening of 15 cm × 15 cm; and an upper plating plate having the same size as the lower plating plate is placed thereon.

### (Examples 9 to 14 and Reference Example 2)

A thermally conductive resin sheet was obtained in the same manner as in Examples 1 to 8 and Reference Example 1 except that the matrix resin and the thermally conductive filler were mixed at room temperature without melt-kneading, and the mixture was used as the press-prepared component.

### (Comparative Example 1)

A thermally conductive resin sheet was obtained in the same manner as in Examples 1 to 8 and Reference Example 1 except that the melt-kneading temperature in the labo plastomill was set to 290°C, and the press-molding temperature was set to 300°C.

### (Comparative Example 2)

The thermally conductive filler 2 was added such that the total amount of the epoxy-based resin composition and the thermally conductive filler 2 was 100% by mass, and 37.2% by mass of a mixed solution of methyl ethyl ketone and cyclohexanone (mixing ratio (volume ratio) 1 : 1) was further added and mixed such that the total solid concentration of the epoxy-based resin composition and the thermally conductive filler 2 was 62.8% by mass to obtain a coating slurry (coating liquid for sheets). At the time of mixing, the materials were stirred for 2 minutes by a planetary stirrer "Awatori Rentaro AR-250" after manual stirring.

The resulting coating slurry was coated on a polyethylene terephthalate film (hereinafter also referred to as "PET film") having a thickness of 38 um by a doctor blade method, heated and dried at 60°C for 120 minutes, and then pressed at a press temperature of 42°C and a press surface pressure of 15 MPa for 10 minutes to obtain an uncured epoxy resin sheet-shaped molded body.

Thereafter, the resulting sheet-shaped molded body was further put into a hot air oven at 170°C for 1 hour together with the PET film to cure the sheet-shaped molded body, and then the PET film was peeled off to obtain a thermally conductive resin sheet having a thickness of 150 um.

### [Preparation of Heat dissipation Circuit Board]

Using the thermally conductive resin sheet obtained in each of Examples 7 and 13, and Comparative Examples 1 and 2, a heat dissipation circuit board was prepared by the following method.

### (Example 7 and Example 13)

The thermally conductive resin sheet was cut into a size of 40 mm × 80 mm; one side of each of a copper plate having a size of 40 mm × 80 mm and a thickness of 2,000 um serving as the heat dissipation metal plate material and a copper plate having a size of 40 mm × 80 mm and a thickness of 500 um serving as the conductive circuit-forming copper plate, was roughened by polishing the surface thereof using #100 sandpaper in advance; the thermally conductive resin sheet was sandwiched with the copper plates such that the roughened surface of each copper plate faced the thermally conductive resin sheet; and these were pressed at a press temperature of 390°C and a press surface pressure of 13 MPa for 10 minutes to obtain a laminated heat dissipation sheet composed of "heat dissipation metal material (copper plate)/thermally conductive resin sheet/conductive circuit-forming copper plate".

Further, the conductive circuit-forming copper plate was etched by a predetermined method and patterned to obtain a heat dissipation circuit board. The pattern was formed in such a manner that two conductive circuit-forming copper plates having a circular pattern of ϕ25 mm remained on the thermally conductive resin sheet of 40 mm × 80 mm.

### (Comparative Example 1)

A heat dissipation circuit board was obtained in the same manner as in Examples 7 and 13 except that the press temperature was set to 300°C.

### (Comparative Example 2)

A heat dissipation circuit board was obtained in the same manner as in Examples 7 and 13 except that the press temperature was set to 175°C.

### <Measurement Conditions and Evaluation Method>

The thermally conductive resin sheet in each of Examples 1 to 14, Comparative Examples 1 and 2, and Reference Examples 1 and 2 was measured and evaluated by the following method.

### [Thermal Conductivity at 25°C]

A thermally conductive resin sheet having a thickness of 500 um in a 15 cm square was prepared by the same production method as in Example 1, and cut into to 10 mm square to use as a measurement sample. A laser light-absorbing spray ("Black Guard Spray FC-153", manufactured by Fine Chemical Japan Co., Ltd.) was thinly coated on both sides of the measurement sample and dried, and then the thermal diffusivity a (mm²/second) in the thickness direction of the resin sheet at a temperature of 25°C was measured by a laser flash method using a xenon flash analyzer ("LFA447·NanoFlash 300", manufactured by NETZSCH). The measurement was performed for 5 points cut out from the same sheet, and the arithmetic average value of these was determined.

The density ρ (g/m³) of the resin sheet was determined using a specific gravity measurement apparatus (manufactured by A&D Company Ltd.), and the specific heat capacity c (J/(g·K)) at 25°C was measured using a DSC measurement apparatus (ThermoPlusEvo DSC8230, manufactured by Rigaku Corp.).

From each of these measured values, the thermal conductivity in the thickness direction of the sheet at 25°C was determined by "H = a × ρ × c".

Here, since there is no JIS standard for the thermal diffusivity and thermal conductivity of resin-based materials, the thermal diffusivity a (mm²/second) is based on JIS R1611·2010 (method of measuring thermal diffusivity, specific heat capacity, and thermal conductivity of fine ceramics by a flash method), and since the standard specifies that "the thickness of the sample is 0.5 mm or more and 5 mm or less", the sample used only for the thermal conductivity measurement is measured with a thickness of 0.5 mm. The density ρ was obtained by the Archimedes method in accordance with JIS K6268. The specific heat capacity c was obtained using a DSC measurement apparatus in accordance with JIS K7123.

### [Evaluation of Retention Rate of Thermal Conductivity at 200°C]

As for the thermally conductive resin sheet in each of Examples 11, 13, and 14, the retention rate of the thermal conductivity at 200°C was evaluated by the following method. The results are shown in Table 3.

The thermal diffusivity a at each temperature was measured in the following conditions: in the laser flash method using the xenon flash analyzer ("LFA447·NanoFlash 300", manufactured by NETZSCH) used for "evaluation of thermal conductivity at 25°C", the step measurement mode was used, the starting temperature was set to 25°C, the interval temperature was set to 25°C, and the temperature was raised to 200°C. These temperatures were those inside the chamber of the measurement apparatus.

The specific heat capacity c was measured up to 250°C using a DSC measurement apparatus, and the specific heat at a temperature corresponding to the measurement temperature of the thermal diffusivity was determined.

As for the density ρ, the measured values were unable to be obtained other than at 25°C. However, since the coefficient of linear expansion in the surface direction of the thermally conductive resin sheet was a relatively small value of 27 ppm between at 180°C and 200°C, the volume change of the thermally conductive resin sheet of the present invention between 25°C and 200°C was not considered to be significant, and the measured value at 25°C was thus used as it was.

As for the measurement of the coefficient of linear expansion, the thermally conductive resin sheet having a thickness of 150 um was used and measured in the tensile mode, in accordance with JIS K7197·1991.

As for the coefficient of linear expansion of the PEEK resin of the sheet, in the case of "KetaSpire KT-880FP" used in Examples of the present invention, 50 ppm (-50°C to 50°C·ASTM E831) was listed in the catalog, and the coefficient of linear expansion was small even for PEEK alone.

From each of these measured values, the thermal conductivity in the thickness direction of the sheet up to 200°C was determined by "H = a × ρ × c", and the thermal conductivity at each temperature when the thermal conductivity at 25°C was set as 100% was determined as the retention rate (%).

In Reference Example 3, the thermal conductivity at each of the above temperatures of the ceramic-based material "Pyroceram 9696" was transcribed from the values described in "Manufacture's Certification" by NETZSCH (Certificate of "Pyroceram 9696" calibration sample for xenon flash method measurements in accordance with ASTM-E1416) .

### [Dielectric Breakdown Voltage (BDV) Before Moisture Absorption Reflow Test]

The heat dissipation circuit board prepared in each of Examples 7 and 13, and Comparative Examples 1 and 2 was immersed in Fluorinert FC-40 (manufactured by 3M); using an ultra-high voltage withstand voltage tester 7470 (manufactured by Keisoku Giken Co., Ltd.); electrodes of ϕ25 mm were placed on a copper plate of ϕ25 mm patterned by etching on the heat dissipation circuit board; a voltage of 0.5 kV was applied; the voltage was increased by 0.5 kV every 60 seconds; and the measurement was performed until dielectric breakdown. The measurement was performed at a frequency of 60 Hz and a voltage boost rate of 1,000 V/second.

Those having a dielectric breakdown voltage of 40 kV/mm or more per unit thickness (converted value for a thickness of 1 mm) were continuously subjected to the measurement of BDV after the moisture absorption reflow test. Meanwhile, those having a dielectric breakdown voltage of less than 40 kV/mm per unit thickness were listed as "N.D." in Tables 1 and 2.

The evaluation of the dielectric breakdown voltage (BDV) before the moisture absorption reflow test can be regarded as the evaluation of the withstand voltage performance.

### [Dielectric Breakdown Voltage (BDV) After Moisture Absorption Reflow Test]

The heat dissipation circuit board in each of Examples 7 and 13, and Comparative Example 1, whose dielectric breakdown voltage before the moisture absorption reflow test was 40 kV/mm or more, was stored in an environment of 85°C and 85% RH for 3 days using a constant temperature and humidity apparatus, SH-221 (manufactured by ESPEC Corp.); within 30 minutes, the temperature was raised from room temperature to 290°C in 12 minutes under a nitrogen atmosphere; and the temperature was held at 290°C for 10 minutes and then cooled to room temperature (moisture absorption reflow test). Thereafter, the dielectric breakdown voltage was measured in the same manner as above. Those having a dielectric breakdown voltage per unit thickness (converted value for a thickness of 1 mm) of 40 kV/mm or more were described as "O (good)", and those having less than 40 kV/mm were described as "× (poor)". The measurement results are shown in Tables 1 and 2.

The evaluation of the dielectric breakdown voltage (BDV) after the moisture absorption reflow test can be regarded as the evaluation of the moisture absorption reflow tolerance.

### [Interface Observation After Moisture Absorption Reflow Test]

The heat dissipation circuit board prepared in each of Examples 7 and 13, and Comparative Examples 1 and 2 was subjected to the moisture absorption reflow test in the same manner as above, and the interface between the copper electrode of ϕ25 mm patterned by etching and the thermally conductive resin sheet was then observed by an ultrasonic imaging system, FinSAT (FS300III) (manufactured by Hitachi Power Solutions Co., Ltd.). The measurement was performed by placing the sample in water using a probe having a frequency of 50 MHz, at a gain of 30 dB and a pitch of 0.2 mm.

Those having no peeling, floating, or voids observed at the interface were described as "O (good)", and those having peeling, floating, or voids observed at the interface were described as "× (poor)". The evaluation results are also shown in Tables 1 and 2.

The evaluation of the interface observation after the moisture absorption reflow test can be regarded as the evaluation of whether or not deformation due to interface peeling caused by thermal expansion and contraction, and foaming of the thermally conductive resin sheet is likely to occur when the thermally conductive resin sheet is laminated with metal plates to perform a reflow step.

### [Orientation of Primary Particles of Thermally Conductive Filler]

A thermally conductive resin sheet having a thickness of 150 um in a 15 cm square was prepared by the same method as in Examples 7 and 13, and cut into a 40 mm square to prepare a measurement sample. The measurement sample was measured by the X-ray diffraction method, and the ratio "I(002)/I(100)" was determined when the diffraction peak intensity of the (002) plane was defined as I(002) and the diffraction peak intensity of the (100) plane was defined as 1(100). The evaluation results are shown in Tables 1 and 2.

**[Table 1]**

| | | | Example 1 | Example 2 | Example 3 | Example 4 | Example 5 | Example 6 | Example 7 | Example 8 |
|---|---|---|---|---|---|---|---|---|---|---|
| Resin | | | | | | | | | | |
| | PEEK (VESTAKEEP 1000G) | [mass %] | 27 | 23 | 43 | 37 | 37 | 30 | 27 | 23 |
| Thermally conductive filler | | | | | | | | | | |
| | Filler 1 (cabbage structure, agglomerated BN particles) | [mass %] | 73 | 77 | - | - | - | - | - | - |
| | Filler 2 (card-house structure, agglomerated BN particles) | [mass %] | - | - | 57 | 63 | 63 | 70 | 73 | 77 |
| Thermal conductivity (25°C) | | [W/m · K] | 5.38 | 6.17 | 3.73 | 5.03 | 5.11 | 9.39 | 10.3 | 14.1 |
| Dielectric breakdown voltage | | | | | | | | | | |
| | Before moisture absorption reflow test (N.D. means less than 40 kV/mm) | [kV/mm] | - | - | - | - | - | - | 75.8 | - |
| | After moisture absorption reflow test (O means 40 kV/mm or more) | [kV/mm] | - | - | - | - | - | - | O | - |
| Interface observation (after moisture absorption reflow test) | | | - | - | - | - | - | - | O | - |
| Degree of orientation | | [-] | - | - | - | - | - | - | 15.87 | - |
| Remarks | | | | | | | Melt-kneading temperature : 395°C | | | |

**[Table 2]**

| | | | Ex. 9 | Ex. 10 | Ex. 11 | Ex. 12 | Ex. 13 | Ex. 14 | Comparative Example 1 | Comparative Example 2 | Reference Example 1 | Reference Example 2 |
|---|---|---|---|---|---|---|---|---|---|---|---|---|
| Resin | | | | | | | | | | | | |
| | PEEK (VESTAKEEP 1000G) | [mass %] | - | - | - | - | - | - | - | - | 17 | - |
| | PEEK (KetaSpire KT-880FP) | [mass %] | 27 | 43 | 37 | 33 | 27 | 23 | - | - | - | 27 |
| | PBT (NOVADURAN 5010R) | [mass %] | - | - | - | - | - | - | 27 | - | - | - |
| | Bisphenol F-type epoxy resin | [mass %] | - | - | - | - | - | - | - | 8.74 | - | - |
| | Hydrogenated bisphenol A-type liquid epoxy resin | [mass %] | - | - | - | - | - | - | - | 10.93 | - | - |
| | p-Aminophenol-type liquid epoxy resin | [mass %] | - | - | - | - | - | - | - | 2.62 | - | - |
| | Phenol resin-based curing agent (MEH-8000H) | [mass %] | - | - | - | - | - | - | - | 5.73 | - | - |
| | Curing catalyst (C11Z-CN) | [mass %] | - | - | - | - | - | - | - | 0.48 | - | - |
| Thermally conductive filler | | | | | | | | | | | | |
| | Filler 1 (cabbage structure, agglomerated BN particles) | [mass %] | 73 | - | - | - | - | - | - | - | - | - |
| | Filler 2 (card-house structure, agglomerated BN particles) | [mass %] | - | 57 | 63 | 67 | 73 | 77 | 73 | 71.5 | - | - |
| | Filler 3 (flat plate-shaped BN particles) | [mass %] | - | - | - | - | - | - | - | - | 83 | 73 |
| Thermal conductivity (25°C) | | [W/m · K] | 9.71 | 9.24 | 11.7 | 13.5 | 16.2 | 17.4 | 11.7 | 13.3 | 5.92 | 5.62 |
| Dielectric breakdown voltage | | | | | | | | | | | | |
| | Before moisture absorption reflow test (N.D. means less than 40 kV/mm) | [kV/mm] | - | - | - | - | 86.3 | - | 80.6 | N.D. | - | - |
| | After moisture absorption reflow test (O means 40 kV/mm or more) | [kV/mm] | - | - | - | - | ○ | - | × | × | - | - |
| Interface observation (after moisture absorption reflow test) | | | - | - | - | - | ○ | - | × | × | - | - |
| Degree of orientation | | [-] | - | - | - | - | 12.14 | - | - | - | - | - |

**[Table 3]**

| | | | Thermal conductivity measurement temperature | | | | | | | |
|---|---|---|---|---|---|---|---|---|---|---|
| | | | 25°C | 50°C | 75°C | 100°C | 125°C | 150°C | 175°C | 200°C |
| Example 11 | Thermal conductivity | [W/m · K] | 11.7 | 11.9 | 11.9 | 11.7 | 11.7 | 11.5 | 11.3 | 11.2 |
| | Retention rate | [%] | 100 | 102.1 | 101.5 | 100.4 | 99.8 | 98.5 | 96.6 | 95.4 |
| Example 13 | Thermal conductivity | [W/m · K] | 16.2 | 16.4 | 16.1 | 16.1 | 16.1 | 15.9 | 15.5 | 15.1 |
| | Retention rate | [%] | 100 | 101.4 | 99.5 | 99.4 | 99.4 | 98.0 | 95.7 | 93.2 |
| Example 14 | Thermal conductivity | [W/m · K] | 17.4 | 17.6 | 17.3 | 17.4 | 17.0 | 17.1 | 16.8 | 16.5 |
| | Retention rate | [%] | 100 | 101.1 | 99.5 | 99.8 | 97.9 | 98.1 | 93.8 | 94.8 |
| Reference Example 3 | Thermal conductivity | [W/m · K] | 4.01 | 3.91 | N.D. | 3.76 | N.D. | N.D. | N.D. | 3.48 |
| | Retention rate | [%] | 100 | 97.6 | - | 93.8 | - | - | - | 86.8 |

Comparing Examples 7 and 13 with Comparative Examples 1 and 2, the heat dissipation circuit board using the thermally conductive resin sheet in each of Examples 7 and 13 maintained a dielectric breakdown voltage of 40 kV/mm or more both before and after the moisture absorption reflow test. In addition, when the interface between the thermally conductive resin sheet and the copper electrodes was observed after the moisture absorption reflow test, no peeling, floating, or formation of voids was observed.

On the other hand, in Comparative Example 1 using PBT, which was a crystalline thermoplastic resin having a melting point of 224°C, as a matrix resin, the dielectric breakdown voltage before the moisture absorption reflow test was relatively high, but the value after the moisture absorption reflow test was below 40 kV/mm. In addition, when the interface between the thermally conductive resin sheet and the copper electrodes was observed after the moisture absorption reflow test, peeling, floating, and formation of relatively remarkable voids were observed. From the above, it is found that when a thermoplastic resin having a melting point lower than the range of the present invention, such as PBT, is used, it cannot withstand the moisture absorption reflow test, and interface peeling may occur when formed into a laminate with metal plates.

Further, in Comparative Example 2 using the epoxy resin composition, which is a thermosetting resin, as a matrix resin, the dielectric breakdown voltage was lower than 40 kV/mm even before the moisture absorption reflow test. The reason for this is not clear, but it is presumed that the solvent used for coating remained in the resin composition and foamed during thermosetting, and defective parts such as voids were formed.

Furthermore, when the interface between the thermally conductive resin sheet and the copper electrodes was observed after the moisture absorption reflow test, remarkable peeling, floating, and formation of voids were observed. It is generally considered that the thermosetting resin exhibits good heat resistance by being provided with a three-dimensional crosslinked structure even in use at a temperature exceeding the glass transition temperature, but the moisture absorption reflow test is considered to be a severe condition even for the thermosetting resin.

From the above, it is found that the thermally conductive resin sheet of the present invention has good moisture absorption reflow tolerance by using a crystalline thermoplastic resin having a melting point of 300°C or higher as a matrix resin, and the interface peeling due to thermal expansion and contraction is less likely to occur when formed into a laminate with metal plates.

Comparing Examples 1 to 14 with Reference Examples 1 and 2, in the case of using boron nitride as the thermally conductive filler, the thermal conductivity was higher when the boron nitride agglomerated particles were used than when the flat plate-shaped boron nitride primary particles were used. Among them, the thermal conductivity was higher when the boron nitride agglomerated particles having a card-house structure were used than when those having a cabbage structure were used.

More specifically, comparing Example 9 and 13 with Reference Example 2, in the case of using the boron nitride agglomerated particles and the flat plate-shaped boron nitride primary particles in the same amount, the thermally conductive resin sheets in Examples 9 and 13 using the boron nitride agglomerated particles had a higher thermal conductivity.

In addition, comparing Examples 2 and 8 with Reference Example 1, even when the content of the flat plate-shaped boron nitride primary particles was increased, the thermal conductivity thereof did not reach that of the case using the boron nitride agglomerated particles.

Furthermore, comparing Example 1 with Example 7, Example 2 with Example 8, and Example 9 with Example 13, respectively, in the case of using the boron nitride agglomerated particles having a cabbage structure and those having a card-house structure in the same amount, the thermally conductive resin sheets in Examples 7, 8, and 13 having a card-house structure had a higher thermal conductivity.

From the above, it is found that the thermal conductivity of the thermally conductive resin sheet of the present invention was improved by using the boron nitride agglomerated particles as a thermally conductive filler, and among them, the thermal conductivity was further improved by using the boron nitride agglomerated particles having a card-house structure.

Comparing Examples 11, 13, and 14 with Reference Example 3, the thermal conductivity of the thermally conductive resin sheet in each of Examples 11, 13, and 14 in the thickness direction at 200°C was 90% or more of the thermal conductivity in the thickness direction at 25°C, whereas that of the ceramic-based material in Reference Example 3 in the thickness direction at 200°C was reduced to 87% of the thermal conductivity in the thickness direction at 25°C.

From the above, it is found that the thermally conductive resin sheet of the present invention is able to maintain high thermal conductivity even at 200°C.

Comparing Example 4 with Example 5, the thermal conductivity of the thermally conductive resin sheet in Example 5, in which the melt- kneading temperature was set to 395°C, was higher. It is considered that this is because the viscosity of the matrix resin was lowered by raising the melt-kneading temperature, which reduced the shearing stress applied to the thermally conductive filler, and suppressed the crushing of the thermally conductive filler.

Furthermore, comparing Examples 1 to 8 with Examples 9 to 14, the thermal conductivity of the thermally conductive resin sheet in each of Examples 9 to 14, in which the powder raw material of the matrix resin and the powder contaning the thermally conductive filler were stirred and mixed at temperature and heat-press molded without the heat-kneading step, was higher. It is considered that this is because the thermally conductive filler was suppressed from being sheared and crushed by kneading.

From the above, it is found that the thermal conductivity of the thermally conductive resin sheet of the present invention can be increased by changing the type of the matrix resin, the type and content of the thermally conductive filler, the mixing method of the matrix resin and the thermally conductive filler, and the conditions in the heat-kneading step.

## Claims

1. A thermally conductive resin sheet comprising a resin composition containing:
a crystalline thermoplastic resin having a melting point of 300°C or higher; and
a thermally conductive filler comprising boron nitride agglomerated particles,
wherein the crystalline thermoplastic resin comprises a polyetherketone-based resin, and
wherein the melting point is measured by differential scanning calorimetry in accordance with ISO 1183.

2. The thermally conductive resin sheet according to claim 1, wherein the resin composition comprises
15% by mass or more and 40% by mass or less of the crystalline thermoplastic resin; and
60% by mass or more and 85% by mass or less of the thermally conductive filler.

3. The thermally conductive resin sheet according to claim 1 or 2, wherein the thermally conductive filler comprises 50% by mass or more of the boron nitride agglomerated particles.

4. The thermally conductive resin sheet according to any one of claims 1 to 3, wherein the boron nitride agglomerated particles have a card-house structure.

5. The thermally conductive resin sheet according to any one of claims 1 to 4, wherein the thermal conductivity of the thermally conductive resin sheet in a thickness direction at 25°C is 5.0 W/m·K or more, preferably 7.0 W/m·K or more.

6. The thermally conductive resin sheet according to claim 4 or 5, wherein the thermal conductivity of the thermally conductive resin sheet in the thickness direction at 200°C is 90% or more of the thermal conductivity of the thermally conductive resin sheet in the thickness direction at 25°C.

7. The thermally conductive resin sheet according to any one of claims 1 to 6, wherein a thickness of the thermally conductive resin sheet is 50 um or more and 300 um or less.

8. The thermally conductive resin sheet according to any one of claims 1 to 7, wherein the polyetherketone-based resin comprises a polyether-ether-ketone.

9. A laminated heat dissipation sheet, comprising a heat-dissipating metal material laminated on one surface of the thermally conductive resin sheet according to any one of claims 1 to 8.

10. A heat-dissipating circuit board, comprising the laminated heat dissipation sheet according to claim 9.

11. The heat-dissipating circuit board according to claim 10, wherein a conductive circuit is laminated on a surface of the thermally conductive resin sheet which is opposite to a surface on which the heat-dissipating metal material is laminated.

12. The heat-dissipating circuit board according to claim 10 or 11, having a dielectric breakdown voltage of 40 kV/mm or more.

13. A power semiconductor device, comprising the heat-dissipating circuit board according to any one of claims 10 to 12.

14. A method for producing a thermally conductive resin sheet, comprising:
mixing a powder containing a crystalline thermoplastic resin having a melting point of 300°C or higher and a powder containing a thermally conductive filler to produce a resin composition; and
pressing the resin composition with a heating body to form the thermally conductive resin sheet,
wherein the resin composition contains a crystalline thermoplastic resin having a melting point of 300°C or higher and a thermally conductive filler comprising boron nitride agglomerated particles,
wherein the crystalline thermoplastic resin comprises a polyetherketone-based resin, and
wherein the melting point is measured by differential scanning calorimetry in accordance with ISO 1183.

15. The method according to claim 14, wherein the resin composition comprises:
15% by mass or more and 40% by mass or less of the powder containing crystalline thermoplastic resin; and
60% by mass or more and 85% by mass or less of the powder containing the thermally conductive filler.

16. The method according to claim 14 or 15, wherein a D50 ratio of the powder containing thermally conductive filler to the powder containing crystalline thermoplastic resin is 0.3 to 6.0.

## Patentansprüche

1. Wärmeleitende Harzplatte, umfassend eine Harzzusammensetzung, enthaltend:
ein kristallines thermoplastisches Harz mit einem Schmelzpunkt von 300°C oder höher und
einen wärmeleitenden Füllstoff, umfassend agglomerierte Bornitridpartikel,
wobei das kristalline thermoplastische Harz ein Harz auf Polyetherketonbasis umfasst und
wobei der Schmelzpunkt durch Differential-Scanning-Kalorimetrie gemäß ISO 1183 gemessen wird.

2. Wärmeleitende Harzplatte gemäß Anspruch 1, wobei die Harzzusammensetzung
15 Masse-% oder mehr und 40 Masse-% oder weniger des kristallinen thermoplastischen Harzes und
60 Masse-% oder mehr und 85 Masse-% oder weniger des wärmeleitenden Füllstoffs umfasst.

3. Wärmeleitende Harzplatte gemäß Anspruch 1 oder 2, wobei der wärmeleitende Füllstoff 50 Masse-% oder mehr der agglomerierten Bornitridpartikel umfasst.

4. Wärmeleitende Harzplatte gemäß einem der Ansprüche 1 bis 3, wobei die agglomerierten Bornitridpartikel eine Kartenhausstruktur aufweisen.

5. Wärmeleitende Harzplatte gemäß einem der Ansprüche 1 bis 4, wobei die Wärmeleitfähigkeit der wärmeleitenden Harzplatte in einer Dickenrichtung bei 25°C 5,0 W/m·K oder mehr, vorzugsweise 7,0 R/m·K oder mehr, beträgt.

6. Wärmeleitende Harzplatte gemäß Anspruch 4 oder 5, wobei die Wärmeleitfähigkeit der wärmeleitenden Harzplatte in der Dickenrichtung bei 200°C 90 % oder mehr der Wärmeleitfähigkeit der wärmeleitenden Harzplatte in der Dickenrichtung bei 25°C beträgt.

7. Wärmeleitende Harzplatte gemäß einem der Ansprüche 1 bis 6, wobei eine Dicke der wärmeleitenden Harzplatte 50 pm oder mehr und 300 pm oder weniger beträgt.

8. Wärmeleitende Harzplatte gemäß einem der Ansprüche 1 bis 7, wobei das Harz auf Polyetherketonbasis ein Polyether-Ether-Keton umfasst.

9. Laminierte Wärmeableitungsplatte, umfassend ein wärmeableitendes Metallmaterial, das auf einer Oberfläche der wärmeleitenden Harzplatte gemäß einem der Ansprüche 1 bis 8 laminiert ist.

10. Wärmeableitende Leiterplatte, umfassend die laminierte Wärmeableitungsplatte gemäß Anspruch 9.

11. Wärmeableitende Leiterplatte gemäß Anspruch 10, wobei ein leitfähiger Schaltkreis auf einer Oberfläche der wärmeleitenden Harzplatte laminiert ist, die einer Oberfläche, auf der das wärmeleitende Metallmaterial laminiert ist, gegenüberliegt.

12. Wärmeableitende Leiterplatte gemäß Anspruch 10 oder 11 mit einer dielektrischen Durchschlagsspannung von 40 kV/mm oder mehr.

13. Leistungshalbleiterbauelement, umfassend die wärmeableitende Leiterplatte gemäß einem der Ansprüche 10 bis 12.

14. Verfahren zur Herstellung einer wärmeleitenden Harzplatte, umfassend:
Mischen eines Pulvers, das ein kristallines thermoplastisches Harz mit einem Schmelzpunkt von 300°C oder höher enthält, und eines Pulvers, das einen wärmeleitenden Füllstoff enthält, um eine Harzzusammensetzung herzustellen, und
Pressen der Harzzusammensetzung mit einem Heizkörper, um die wärmeleitende Harzplatte zu bilden,
wobei die Harzzusammensetzung ein kristallines thermoplastisches Harz mit einem Schmelzpunkt von 300°C oder höher und einen wärmeleitenden Füllstoff, umfassend agglomerierte Bornitridpartikel, enthält,
wobei das kristalline thermoplastische Harz ein Harz auf Polyetherketonbasis umfasst und
wobei der Schmelzpunkt durch Differential-Scanning-Kalorimetrie gemäß ISO 1183 gemessen wird.

15. Verfahren gemäß Anspruch 14, wobei die Harzzusammensetzung umfasst:
15 Masse-% oder mehr und 40 Masse-% oder weniger des Pulvers, das das kristalline thermoplastische Harz enthält, und
60 Masse-% oder mehr und 85 Masse-% oder weniger des Pulvers, das den wärmeleitenden Füllstoff enthält.

16. Verfahren gemäß Anspruch 14 oder 15, wobei ein D50-Verhältnis des Pulvers, das den wärmeleitenden Füllstoff enthält, zu dem Pulver, das das kristalline thermoplastische Harz enthält, 0,3 bis 6,0 beträgt.

## Revendications

1. Feuille de résine thermoconductrice comprenant une composition de résine contenant :
une résine thermoplastique cristalline présentant un point de fusion de 300 °C ou plus ; et
une charge thermoconductrice comprenant des particules agglomérées de nitrure de bore,
dans lequel la résine thermoplastique cristalline comprend une résine à base de polyéthercétone, et
dans laquelle le point de fusion est mesuré par analyse calorimétrique différentielle conformément à la norme ISO 1183.

2. Feuille de résine thermoconductrice selon la revendication 1, dans laquelle la composition de résine comprend
15 % en masse ou plus et 40 % en masse ou moins de la résine thermoplastique cristalline ; et
60 % en masse ou plus et 85 % en masse ou moins de la charge thermoconductrice.

3. Feuille de résine thermoconductrice selon la revendication 1 ou la revendication 2, dans laquelle la charge thermoconductrice comprend 50 % en masse ou plus des particules agglomérées de nitrure de bore.

4. Feuille de résine thermoconductrice selon l'une quelconque des revendications 1 à 3, dans laquelle les particules agglomérées de nitrure de bore présentent une structure en château de cartes.

5. Feuille de résine thermoconductrice selon l'une quelconque des revendications 1 à 4, dans laquelle la conductivité thermique de la feuille de résine thermoconductrice dans une direction d'épaisseur à 25 °C est de 5,0 W/m·K ou plus, de préférence de 7,0 W/m·K ou plus.

6. Feuille de résine thermoconductrice selon la revendication 4 ou la revendication 5, dans laquelle la conductivité thermique de la feuille de résine thermoconductrice dans la direction d'épaisseur à 200 °C est de 90 % ou plus de la conductivité thermique de la feuille de résine thermoconductrice dans la direction d'épaisseur à 25 °C.

7. Feuille de résine thermoconductrice selon l'une quelconque des revendications 1 à 6, dans laquelle une épaisseur de la feuille de résine thermoconductrice est de 50 µm ou plus et de 300 µm ou moins.

8. Feuille de résine thermoconductrice selon l'une quelconque des revendications 1 à 7, dans laquelle la résine à base de polyéthercétone comprend un polyéther-éther-cétone.

9. Feuille stratifiée de dissipation thermique, comprenant un matériau métallique de dissipation thermique stratifié sur une surface de la feuille de résine thermoconductrice selon l'une quelconque des revendications 1 à 8.

10. Carte de circuit imprimé dissipant la chaleur, comprenant la feuille stratifiée de dissipation thermique selon la revendication 9.

11. Carte de circuit imprimé dissipant la chaleur selon la revendication 10, dans laquelle un circuit conducteur est stratifié sur une surface de la feuille de résine thermoconductrice qui est opposée à une surface sur laquelle le matériau métallique de dissipation thermique est stratifié.

12. Carte de circuit imprimé dissipant la chaleur selon la revendication 10 ou la revendication 11, présentant une tension de claquage diélectrique de 40 kV/mm ou plus.

13. Dispositif semi-conducteur de puissance, comprenant la carte de circuit imprimé dissipant la chaleur selon l'une quelconque des revendications 10 à 12.

14. Procédé de production d'une feuille de résine thermoconductrice, comprenant :
le mélange d'une poudre contenant une résine thermoplastique cristalline présentant un point de fusion de 300 °C ou plus et d'une poudre contenant une charge thermoconductrice pour produire une composition de résine ; et
le pressage de la composition de résine avec un corps chauffant pour former la feuille de résine thermoconductrice,
dans lequel la composition de résine contient une résine thermoplastique cristalline présentant un point de fusion de 300 °C ou plus et une charge thermoconductrice comprenant des particules agglomérées de nitrure de bore,
dans lequel la résine thermoplastique cristalline comprend une résine à base de polyéthercétone, et
dans laquelle le point de fusion est mesuré par analyse calorimétrique différentielle conformément à la norme ISO 1183.

15. Procédé selon la revendication 14, dans lequel la composition de résine comprend :
15 % en masse ou plus et 40 % en masse ou moins de la poudre contenant une résine thermoplastique cristalline ; et
60 % en masse ou plus et 85 % en masse ou moins de la poudre contenant la charge thermoconductrice.

16. Procédé selon la revendication 14 ou la revendication 15, dans lequel un rapport D50 de la poudre contenant une charge thermoconductrice par rapport à la poudre contenant une résine thermoplastique cristalline est de 0,3 à 6,0.
